# EUROPEAN PATENT APPLICATION

(11) **EP 4 718 082 A1**
(43) Date of publication of application: **01.04.2026**
(21) Application number: 25203686.8
(22) Date of filing: 22.09.2025
(51) Int. Cl.: G01R 15/20

(54) **CURRENT MEASUREMENT SYSTEM, CURRENT MEASUREMENT APPARATUS, CURRENT MEASUREMENT METHOD, AND CURRENT MEASUREMENT PROGRAM**

(30) Priority: 25.09.2024 JP 2024166192
(71) Applicant: Yokogawa Electric Corporation, Tokyo 180-8750 (JP)
(72) Inventor: NOGUCHI, Naoki, Musashino-shi, Tokyo, 180-8750, (JP); SAKAMAKI, Yasuo, Musashino-shi, Tokyo, 180-8750, (JP); TAKENAKA, Kazuma, Musashino-shi, Tokyo, 180-8750, (JP); TERAO, Minako, Musashino-shi, Tokyo, 180-8750, (JP)
(74) Representative: Winter, Brandl - Partnerschaft mbB

(57) **Abstract**

A current measurement system includes a magnetic field shield (3) that is configured to capture, to the inside thereof, a magnetic field (H) that is generated by a current (I) that flows through a cable (9), a magnetic field sensor (4) that is installed inside the magnetic field shield (3), a predetermined sensor, and a current measurement apparatus (2). The predetermined sensor is a sensor for detecting the cable (9), the magnetic field sensor (4) detects the magnetic field (H) at an installation location, the current measurement apparatus (2) acquires a detection result of the predetermined sensor and a detection result of the magnetic field sensor (4), identifies a center position of the cable (9) based on the acquired detection result of the predetermined sensor, and calculates a current value of the current (I) that flows through the cable (9) based on the identified center position and the acquired detection result of the magnetic field sensor (4).

## Description

### FIELD

The present invention relates to a current measurement system, a current measurement apparatus, a current measurement method, and a current measurement program.

### BACKGROUND

A current measurement apparatus that measures a magnetic field that is generated from a current that flows through a cable that is a conductor as a measurement target, and measures the current that flows through the cable from the measured magnetic field is known (see, for example, Japanese Laid-open Patent Publication No. 2020-38113). Further, as the current measurement apparatus as described above, a current measurement apparatus that includes an approximately U-shaped magnetic field shield that is installed inside a sensor head, a cable that is a conductor installed in the magnetic field shield, and a magnetic field sensor that is installed inside the magnetic field shield is known.

However, it is difficult to improve measurement accuracy of a current that flows through a conductor. For example, in the technology as described above, when a center position of the cable through which the current flows is not accurately identified, it is difficult to calculate an accurate current value by using a sensor value that is detected by the magnetic sensor.

The present invention has been conceived in view of the foregoing situation, and it is possible to improve measurement accuracy of a current that flows through a conductor.

### SUMMARY

According to an aspect of the embodiments, a current measurement system includes a magnetic field shield that is configured to capture, to an inside of the magnetic field shield, a magnetic field that is generated by a current that flows through a conductor, a magnetic field sensor that is installed inside the magnetic field shield, a predetermined sensor, and a current measurement apparatus, wherein the predetermined sensor is a sensor for detecting the conductor, the magnetic field sensor detects a magnetic field at an installation location, and the current measurement apparatus includes an acquisition unit that acquires a detection result of the predetermined sensor and a detection result of the magnetic field sensor, an identification unit that identifies a center position of the conductor based on the acquired detection result of the predetermined sensor, and a calculation unit that calculates a current value of the current that flows through the conductor based on the identified center position and the acquired detection result of the magnetic field sensor.

According to an aspect of the embodiments, a current measurement apparatus includes an acquisition unit that acquires a detection result of a conductor that is detected by a predetermined sensor, and acquires a detection result of a magnetic field that is detected at an installation location by a magnetic field sensor that is installed inside a magnetic field shield that is configured to capture, to an inside of the magnetic field shield, a magnetic field that is generated by a current that flows through the conductor, an identification unit that identifies a center position of the conductor based on the acquired detection result of the predetermined sensor, and a calculation unit that calculates a current value of the current that flows through the conductor based on the identified center position and the acquired detection result of the magnetic field sensor.

A current measurement method implemented by a computer, the current measurement method includes acquiring a detection result of a conductor that is detected by a predetermined sensor, acquiring a detection result of a magnetic field that is detected at an installation location by a magnetic field sensor that is installed inside a magnetic field shield that is configured to capture, to an inside of the magnetic field shield, a magnetic field that is generated by a current that flows through the conductor, identifying a center position of the conductor based on the acquired detection result of the predetermined sensor, and calculating a current value of the current that flows through the conductor based on the identified center position and the acquired detection result of the magnetic field sensor.

According to an aspect of the embodiments, a current measurement program that causes a computer to execute a process, the process includes acquiring a detection result of a conductor that is detected by a predetermined sensor, acquiring a detection result of a magnetic field that is detected at an installation location by a magnetic field sensor that is installed inside a magnetic field shield that is configured to capture, to an inside of the magnetic field shield, a magnetic field that is generated by a current that flows through the conductor, identifying a center position of the conductor based on the acquired detection result of the predetermined sensor, and calculating a current value of the current that flows through the conductor based on the identified center position and the acquired detection result of the magnetic field sensor.

### BRIEF DESCRIPTION OF THE DRAWINGS

FIG. 1 is a diagram illustrating a configuration example and a process example of a current measurement system according to a first embodiment;
FIG. 2 is a diagram illustrating a configuration example of a magnetic field shield according to the first embodiment;
FIG. 3 is a diagram illustrating a configuration example of a sensor head according to the first embodiment;
FIG. 4 is a block diagram illustrating a configuration example of each of apparatuses of the current measurement system according to the first embodiment;
FIG. 5 is a diagram illustrating an example of a first detected data storage unit of the current measurement apparatus according to the first embodiment;
FIG. 6 is a diagram illustrating an example of a first location data storage unit of the current measurement apparatus according to the first embodiment;
FIG. 7 is a diagram illustrating an example of a current data storage unit of the current measurement apparatus according to the first embodiment;
FIG. 8 is a flowchart illustrating an example of the flow of processes of the current measurement system according to the first embodiment;
FIG. 9 is a diagram illustrating a configuration example and a process example of a current measurement system according to a second embodiment;
FIG. 10 is a diagram illustrating a configuration example of a sensor head according to the second embodiment;
FIG. 11 is a block diagram illustrating a configuration example of each of apparatuses of the current measurement system according to the second embodiment;
FIG. 12 is a diagram illustrating an example of a second detected data storage unit of the current measurement apparatus according to the second embodiment;
FIG. 13 is a diagram illustrating an example of a second location data storage unit of the current measurement apparatus according to the second embodiment;
FIG. 14 is a flowchart illustrating an example of the flow of processes of the current measurement system according to the second embodiment;
FIG. 15 is a diagram illustrating a configuration example and a process example of a current measurement system according to a third embodiment;
FIG. 16 is a diagram illustrating a configuration example of a sensor head according to the third embodiment;
FIG. 17 is a diagram illustrating a configuration example 1-1 of a cable fixture according to the third embodiment;
FIG. 18 is a diagram illustrating a configuration example 1-2 of the cable fixture according to the third embodiment;
FIG. 19 is a diagram illustrating a configuration example 2-1 of the cable fixture according to the third embodiment;
FIG. 20 is a diagram illustrating a configuration example 2-2 of the cable fixture according to the third embodiment;
FIG. 21 is a block diagram illustrating a configuration example of each of apparatuses of the current measurement system according to the third embodiment;
FIG. 22 is a diagram illustrating an example of a third detected data storage unit of the current measurement apparatus according to the third embodiment;
FIG. 23 is a diagram illustrating an example of a third location data storage unit of the current measurement apparatus according to the third embodiment;
FIG. 24 is a flowchart illustrating an example of the flow of processes of the current measurement system according to the third embodiment; and
FIG. 25 is a diagram illustrating a configuration example of hardware according to the first embodiment to the third embodiment.

### DETAILED DESCRIPTION OF THE PREFERRED EMBODIMENTS

Embodiments of a current measurement system, a current measurement apparatus, a current measurement method, and a current measurement program of the present invention will be described in detail below with reference to the drawings. Meanwhile, the present invention is not limited by a first embodiment to a third embodiment as described below.

### First embodiment

A configuration and a process of a current measurement system 100-1 according to the first embodiment, a configuration and a process of each of apparatuses of the current measurement system 100-1, the flow of each of processes of the current measurement system 100-1, and effects of the first embodiment will be described below.

### 1. Configuration and process of current measurement system 100-1

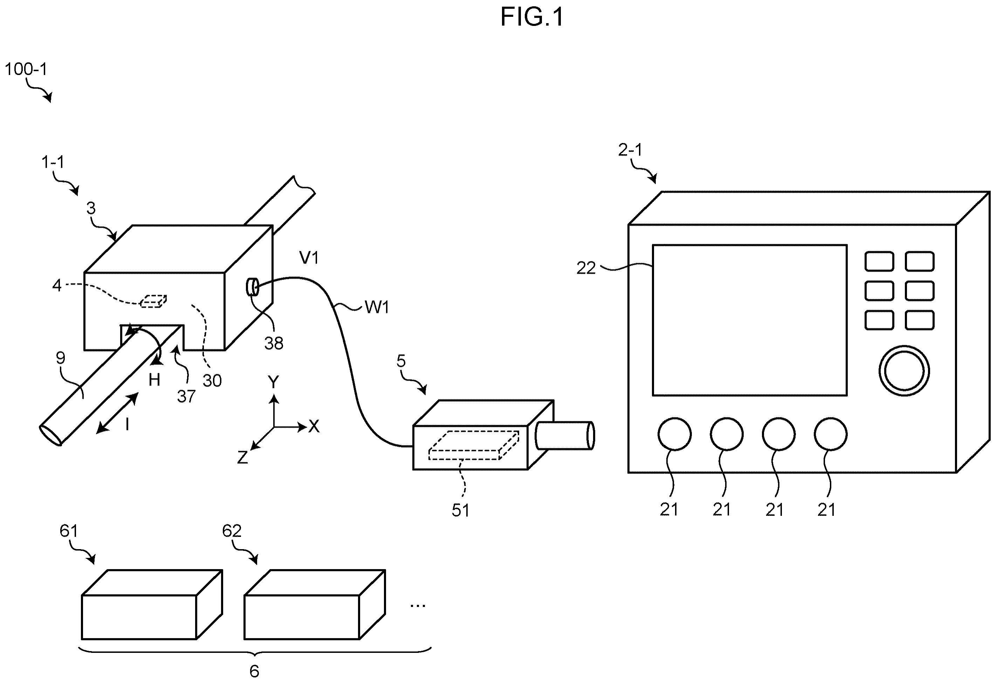

The configuration and the process of the current measurement system 100-1 according to the first embodiment will be described with reference to FIG. 1 to FIG. 3. In the following, a configuration example of the entire current measurement system 100-1, a configuration example of a magnetic field shield 3, a configuration example of a cable 9, a configuration example of a sensor head 1-1, a process example of the current measurement system 100-1, and effects of the current measurement system 100-1 will be described.

### 1-1. Configuration example of entire current measurement system 100-1

A configuration example of the entire current measurement system 100-1 will be described with reference to FIG. 1. FIG. 1 is a diagram illustrating a configuration example and a process example of the current measurement system 100-1 according to the first embodiment. The current measurement system 100-1 includes the sensor head 1-1, a current measurement apparatus 2-1, a probe 5, and distance sensors 6. Here, the sensor head 1-1, the current measurement apparatus 2-1, the probe 5, and the distance sensors 6 are communicably connected to one another in a wired or wireless manner via a predetermined communication network. Meanwhile, as the predetermined communication network, it is possible to adopt various kinds of communication networks, such as the Internet or a dedicated line.

### 1-1-1. Sensor head 1-1

The sensor head 1-1 is a sensor device that is installed in the cable 9 that is a conductor as a measurement target, and measures a magnetic field H that is generated by a current I that flows through the cable 9. The sensor head 1-1 is covered by the magnetic field shield 3 that has a partly-opened bottom surface, and a magnetic field sensor 4 is installed inside the sensor head 1-1. Meanwhile, the current measurement system 100-1 illustrated in FIG. 1 may include the plurality of sensor heads 1-1.

Here, a direction of the current I that flows through the cable 9 is schematically illustrated by an arrow in the drawing. The current I may be a direct current or an alternating current. A frequency (reference frequency) of the current I will be referred to as a frequency f. Further, a direction of the magnetic field H that is generated by the current I that flows through the cable 9 is schematically illustrated by an arrow in the drawing.

An XYZ coordinate system will be described below. A Z-axis direction corresponds to an extending direction of the cable 9. An X-axis direction and a Y-axis direction (XY plane direction) correspond to a cross-sectional direction of the cable 9. A positive X-axis direction and a negative X-axis direction may also be referred to as a left-right direction or the like. A positive Y-axis direction and a negative Y-axis direction may also be referred to as a vertical direction or the like. A positive Z-axis direction and a negative Z-axis direction may also be referred to as a front-back direction or the like.

The magnetic field shield 3 captures (a part of) the magnetic field H that is generated by the current I that flows through the cable 9 into an internal space 30 via an opening portion 37. Further, the magnetic field sensor 4 detects the magnetic field H that is captured into the internal space 30 of the magnetic field shield 3 and outputs the magnetic field H as a sensor voltage value V1. In this case, the magnetic field sensor 4 outputs the sensor voltage value V1 to a detection circuit 51 that is incorporated in the probe 5, via a terminal 38 of the magnetic field shield 3 and wiring W1.

### 1-1-2. Current measurement apparatus 2-1

The current measurement apparatus 2-1 is an apparatus that identifies a cable center position CC of the cable 9 and measures the current I that flows through the cable 9. Meanwhile, the current measurement system 100-1 illustrated in FIG. 1 may include the plurality of current measurement apparatuses 2-1. Further, in the example illustrated in FIG. 1, a case is illustrated in which the current measurement apparatus 2-1 is implemented by an oscilloscope, but the current measurement apparatus 2-1 may be implemented by a desktop Personal Computer (PC), a notebook PC, a smartphone, a server apparatus, a cloud system, or the like.

The current measurement apparatus 2-1 includes an input unit 21 and an output unit 22. In the example illustrated in FIG. 1, the input unit 21 is an input terminal and connected to the probe 5. Further, the output unit 22 is a display and displays a waveform of the measured current I.

### 1-1-3. Probe 5

The probe 5 is a device that is communicably connected between the current measurement apparatus 2-1 and the sensor head 1-1 by the wiring W1 and incorporates therein the detection circuit 51 that converts the sensor voltage value V1 that is detected by the sensor head 1-1. Meanwhile, the current measurement system 100-1 illustrated in FIG. 1 may include the plurality of probes 5. Further, the probe 5 may be integrated with the sensor head 1-1 or the current measurement apparatus 2-1.

### 1-1-4. Distance sensor 6

The distance sensors 6 (61, 62, ...) are sensor devices that are communicably connected to the current measurement apparatus 2-1 in a wired or wireless manner and detect distance data D₁ that indicates a distance between the cable 9 and each of the distance sensors 6. For example, the distance sensors 6 are implemented by a radar sensor 6A and an imaging sensor 6B.

### 1-2. Configuration example of magnetic field shield 3

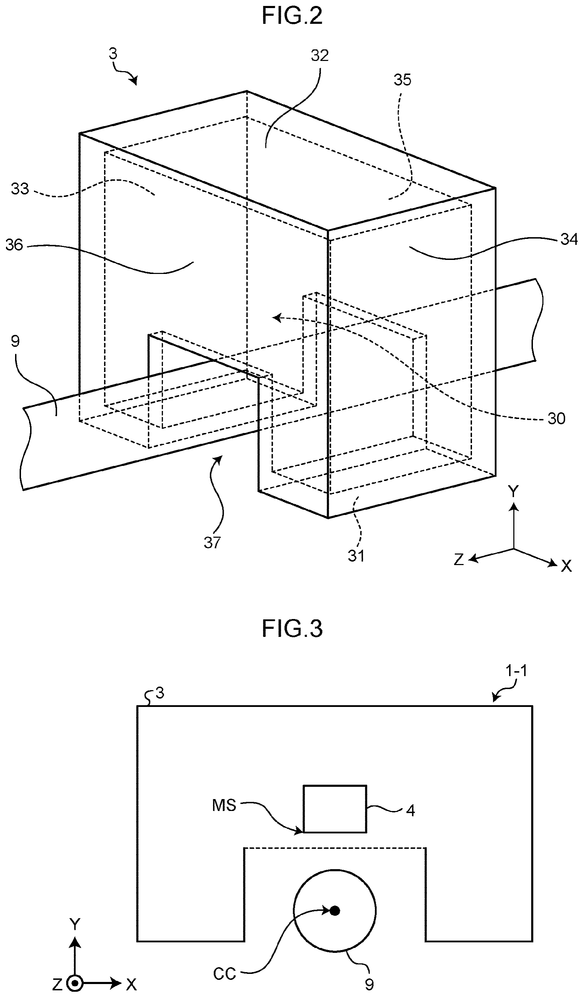

A configuration example of the magnetic field shield 3 will be described with reference to FIG. 2. FIG. 2 is a diagram illustrating a configuration example of the magnetic field shield 3 according to the first embodiment. The magnetic field shield 3 has an approximately box shape with a hollow. The magnetic field shield 3 includes a bottom plate 31, a top plate 32, a side plate 33, a side plate 34, a side plate 35, and a side plate 36. Further, the bottom plate 31, the top plate 32, the side plate 33, the side plate 34, the side plate 35, and the side plate 36 define a shape of the magnetic field shield 3 such that the magnetic field shield 3 includes the internal space 30 inside thereof and includes the opening portion 37.

The bottom plate 31 and the top plate 32 are installed on opposite sides across the internal space 30 in the vertical direction (Y-axis direction), and extend so as to face each other while adopting an XZ plane direction as plane directions. The bottom plate 31, the internal space 30, and the top plate 32 are installed in this order in the positive Y-axis direction.

The side plate 33 and the side plate 34 are located on opposite sides across the internal space 30 in the left-right direction (X-axis direction), and extend so as to face each other while adopting a YZ plane direction as plane directions. The side plate 33, the internal space 30, and the side plate 34 are located in this order in the positive X-axis direction.

The side plate 35 and the side plate 36 are located on opposite sides across the internal space 30, the front-back direction (Z-axis direction), and extend so as to face each other while adopting the XY plane direction as plane directions. The side plate 35, the internal space 30, and the side plate 36 are located in this order in the positive Z-axis direction.

In the example illustrated in FIG. 2, the opening portion 37 is formed by cutting a part of the bottom plate 31, the side plate 35, and the side plate 36, and is present throughout magnetic field shield 3 in the front-back direction (Z-axis direction). An area of the opening portion 37 (the size of the opening) in the XY plane direction is designed such that the cable 9 can pass through the opening portion 37.

The inside of the magnetic field shield 3 indicates the internal space 30 of the magnetic field shield 3 unless otherwise specified. The phrases of "the inside of the magnetic field shield 3" and "the internal space 30" may be replaced with each other to the extent that there is no contradiction.

### 1-3. Configuration example of cable 9

The cable 9 as the conductor is installed in, for example, a Hybrid Vehicle (HV), an Electric Vehicle (EV), or the like and used to allow a current of several amperes, several dozens of amperes, or more to flow. Examples of the cable 9 include a cable and a bus bar that connect a battery and a power unit or connect a converter and an inverter.

### 1-4. Configuration example of sensor head 1-1

A configuration example the sensor head 1-1 will be described with reference to FIG. 3. FIG. 3 is a diagram illustrating a configuration example of the sensor head 1-1 according to the first embodiment. The sensor head 1-1 includes the magnetic field shield 3 and the magnetic field sensor 4. In the example illustrated in FIG. 3, the sensor head 1-1 is mounted on the cable 9 so as to pass through the opening portion 37 below the magnetic field sensor 4. In this case, the sensor head 1-1 may use, for example, a hook-shaped member, a ring-shaped member or the like for mounting the magnetic field shield 3 on the cable 9, or a spring member for fixing the mounted state. Further, the sensor head 1-1 includes the magnetic field sensor 4 inside the magnetic field shield 3 such that the magnetic field sensor 4 is located in the vertical direction of the cable 9, but an installation location of the magnetic field sensor 4 is not specifically limited. In the following explanation, the installation location of the magnetic field sensor 4 in the XZ plane direction of the sensor head 1-1 is referred to as a magnetic field sensor location MS, and a center of the cable 9 in the XY plane direction located closest to the magnetic field sensor location MS is referred to as the cable center position CC.

### 1-5. Process example of current measurement system 100-1

A process example of the current measurement system 100-1 will be described. In the following, a distance data measurement process, a distance data acquisition process, a cable center position identification process, and a current data calculation process will be described. Meanwhile, the processes as described above may be performed in a different order. Further, any of the processes as described above may be omitted.

### 1-5-1. Distance data measurement process

Firstly, the distance sensors 6 measure distance data D₁ with respect to the cable 9. For example, the distance sensor 61 measures distance data D₁(1) that indicates a distance between the distance sensor 61 and a surface of the cable 9. Further, the distance sensor 62 measures distance data D₁(2) between the distance sensor 62 and the surface of the cable 9.

### 1-5-2. Distance data acquisition process

Secondly, the current measurement apparatus 2-1 acquires the distance data D₁ from the distance sensors 6. For example, the current measurement apparatus 2-1 acquires the distance data D₁(1) that is measured by the distance sensor 61. Further, the current measurement apparatus 2-1 acquires the distance data D₁(2) that is measured by the distance sensor 62.

### 1-5-3. Cable center position identification process

Thirdly, the current measurement apparatus 2-1 identifies the cable center position CC of the cable 9. For example, the current measurement apparatus 2-1 identifies the cable center position CC of the cable 9 by using the pieces of distance data D₁(1), D₁(2), ... that are acquired from the plurality of distance sensors 6 (61, 62, ...). At this time, the current measurement apparatus 2-1 identifies the cable center position CC by further using distance sensor locations DS of the distance sensors 6, the magnetic field sensor location MS of the magnetic field sensor 4, and a cable radius d of the cable 9 that are setting values.

### 1-5-4. Current data calculation process

Fourthly, the current measurement apparatus 2-1 calculates current data A of the current I that flows through the cable 9. For example, the current measurement apparatus 2-1 calculates the current data A that indicates a current value (A) of the current I that flows through the cable 9 at regular time intervals by using the identified cable center position CC of the cable 9 and the magnetic field data M that is acquired from the magnetic field sensor 4.

### 1-6. Effect of the current measurement system 100-1

An overview of the current measurement system 100-1 according to the first embodiment will be first described, and thereafter, an effect of the current measurement system 100-1 will be described.

### 1-6-1. Overview of current measurement system 100-1

An overview of the current measurement system 100-1 according to the first embodiment will be described. The current measurement system 100-1 performs processes as described below. Firstly, the distance sensors 6 measure the distance data D₁ that indicates the distance to the cable 9. Secondly, the current measurement apparatus 2-1 acquires the distance data D₁ from the distance sensors 6. Thirdly, the current measurement apparatus 2-1 identifies the cable center position CC of the cable 9 by using the distance data D₁. Fourthly, the current measurement apparatus 2-1 calculates the current data A that indicates the current value (A) of the current I that flows through the cable 9 by using the cable center position CC and the magnetic field data M.

### 1-6-2. Effect of current measurement system 100-1

An effect of the current measurement system 100-1 according to the first embodiment will be described. The current measurement system 100-1 collects the distance data D₁ of the distances to the cable 9 by the distance sensors 6, such as the radar sensor 6A and the imaging sensor 6B, that are installed outside the sensor head 1-1, and accurately identifies the cable center position CC for calculating the current value (A) of the current I that flows through the cable 9. Therefore, the current measurement system 100-1 is able to improve measurement accuracy of the current I that flows through the cable 9.

### 2. Configuration and process of each of apparatuses of current measurement system 100-1

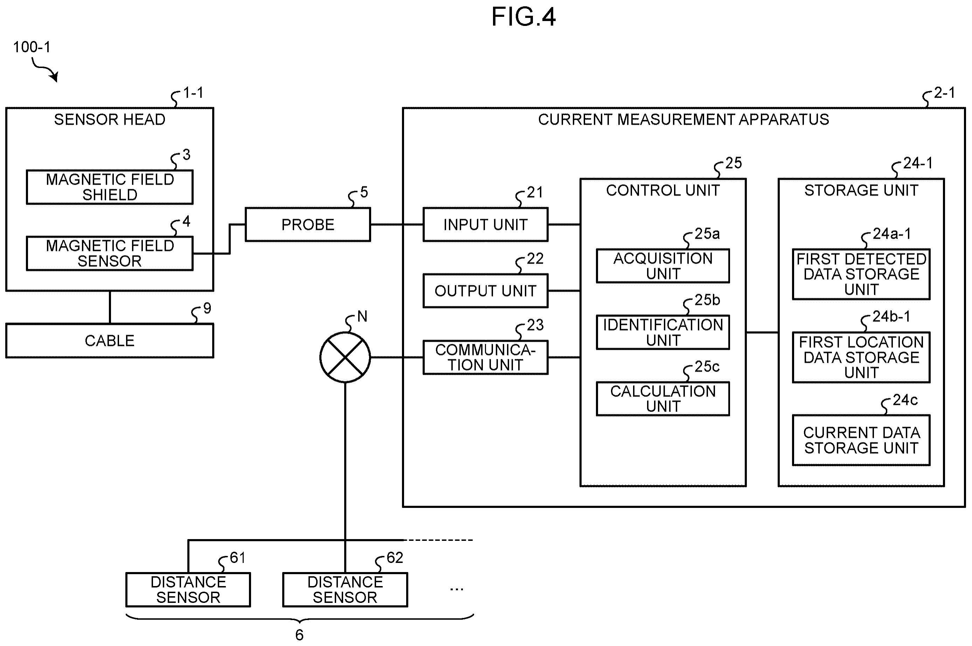

A configuration and a process of each of apparatuses included in the current measurement system 100-1 illustrated in FIG. 1 will be described with reference to FIG. 4 to FIG. 7. In the following, a configuration example of the entire current measurement system 100-1 according to the first embodiment, a configuration example and a process example of the sensor head 1-1, a configuration example and a process example of the current measurement apparatus 2-1, a configuration example and a process example of the probe 5, and a configuration example and a process example of the distance sensor 6 will be described.

### 2-1. Configuration example of entire current measurement system 100-1

A configuration example of the entire current measurement system 100-1 illustrated in FIG. 1 will be described with reference to FIG. 4. FIG. 4 is a block diagram illustrating a configuration example of each of apparatuses of the current measurement system 100-1 according to the first embodiment. As illustrated in FIG. 4, the current measurement system 100-1 includes the sensor head 1-1, the current measurement apparatus 2-1, the probe 5, and the distance sensors 6. Further, the sensor head 1-1 and the current measurement apparatus 2-1 are communicably connected to each other by a dedicated line or the like via the probe 5. Furthermore, the current measurement apparatus 2-1 and the distance sensors 6 are communicably connected by the communication network N that is implemented by the Internet, a dedicated line, or the like.

### 2-2. Configuration example and process example of sensor head 1-1

A configuration example and a process example of the sensor head 1-1 will be described with reference to FIG. 4. As illustrated in FIG. 4, the sensor head 1-1 includes the magnetic field shield 3 and the magnetic field sensor 4 and is installed in the cable 9 as the conductor.

### 2-2-1. Magnetic field shield 3

The magnetic field shield 3 is configured to capture, to the inside thereof, the magnetic field H that is generated by the current I that flows through the cable 9. Further, the magnetic field shield 3 is configured to shield the magnetic field H. The magnetic field shield 3 may be made by using various kinds of well-known materials, such as a metal material.

### 2-2-2. Magnetic field sensor 4

The magnetic field sensor is installed inside the magnetic field shield 3. Further, the magnetic field sensor 4 detects the magnetic field H at the magnetic field sensor location MS that is an installation location. For example, the magnetic field sensor 4 is an Integrated Circuit (IC) sensor that includes a Hall element, and may be referred to as an analog Hall IC or the like. Furthermore, the magnetic field sensor 4 may be a coil sensor that includes a coil. In this case, it may be possible to use a Rogowski coil as the magnetic field sensor 4, which enables downsizing and makes it possible to easily arrange the magnetic field sensor 4 in the magnetic field shield 3.

### 2-3. Configuration example and process example of current measurement apparatus 2-1

A configuration example and a process example of the current measurement apparatus 2-1 will be described with reference to FIG. 4. As illustrated in FIG. 4, the current measurement apparatus 2-1 includes the input unit 21, the output unit 22, a communication unit 23, a storage unit 24-1, and a control unit 25.

### 2-3-1. Input unit 21

The input unit 21 controls input of various kinds of information to the current measurement apparatus 2-1. For example, the input unit 21 is implemented by an input terminal or the like, and receives input of various kinds of information to the current measurement apparatus 2-1.

### 2-3-2. Output unit 22

The output unit 22 controls output of various kinds of information from the current measurement apparatus 2-1. For example, the output unit 22 is implemented by a display or the like, and displays various kinds of information that are stored in the current measurement apparatus 2-1.

### 2-3-3. Communication unit 23

The communication unit 23 controls data communication with a different apparatus. For example, the communication unit 23 performs data communication with each of communication apparatuses via a router or the like. Further, the communication unit 23 is able to perform data communication with a terminal (not illustrated).

### 2-3-4. Storage unit 24-1

The storage unit 24-1 stores therein various kinds of information that are referred to when the control unit 25 operates and various kinds of information that are acquired when the control unit 25 operates. The storage unit 24-1 includes a first detected data storage unit 24a-1, a first location data storage unit 24b-1, and a current data storage unit 24c. Here, the storage unit 24-1 may be implemented by, for example, a semiconductor memory device, such as a Random Access Memory (RAM) or a flash memory, a storage device, such as a hard disk or an optical disk, or the like. Meanwhile, in the example illustrated in FIG. 4, the storage unit 24-1 is installed inside the current measurement apparatus 2-1, but the storage unit 24-1 may be installed outside the current measurement apparatus 2-1 or it may be possible to install a plurality of storage units.

### 2-3-4-1. First detected data storage unit 24a-1

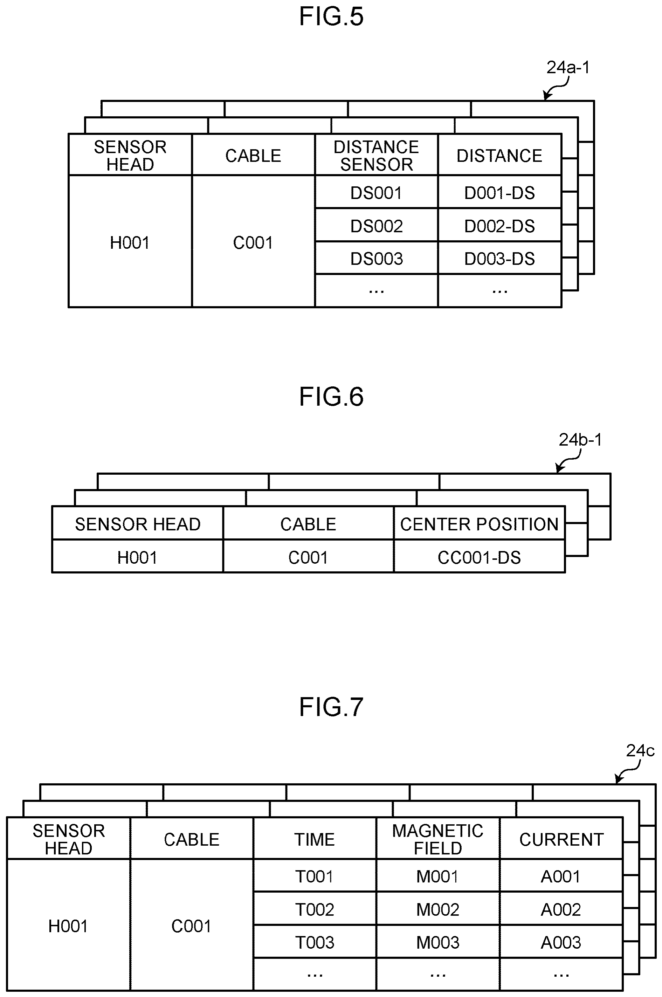

The first detected data storage unit 24a-1 stores therein first detected data. For example, the first detected data storage unit 24a-1 stores therein, as the first detected data, the distance data D₁ that corresponds to a sensor value detected by the distance sensor 6 and that is acquired by an acquisition unit 25a of the control unit 25 (to be described later). An example of data that is stored in the first detected data storage unit 24a-1 will be described below with reference to FIG. 5. FIG. 5 is a diagram illustrating an example of the first detected data storage unit 24a-1 of the current measurement apparatus 2-1 according to the first embodiment. In the example illustrated in FIG. 5, the first detected data storage unit 24a-1 includes items such as a "sensor head", a "cable", a "distance sensor", and a "distance".

The "sensor head" indicates identification information for identifying the sensor head 1-1, and is, for example, an identification number or an identification symbol of the sensor head 1-1. The "cable" indicates identification information for identifying the cable 9 that is a conductor wire as a measurement target, and is, for example, an identification number or an identification symbol of the cable 9 on which the sensor head 1-1 is mounted. The "distance sensor" indicates identification information for identifying the distance sensor 6, and is, for example, an identification number or an identification symbol of the distance sensor 6. The "distance" is the distance data D₁ between the distance sensor 6 and the surface of the cable 9, and is represented by, for example, millimeters (mm), centimeters (cm), meters (m), or the like.

Specifically, FIG. 5 illustrates an example in which the first detected data storage unit 24a-1 stores therein data or the like including the distance data D₁ of {distance sensor: "DS001", distance: "D001-DS"}, {distance sensor: "DS002", distance: "D002-DS"}, {distance sensor: "DS003", distance: "D003-DS"}, ..., with respect to the sensor head 1-1 that is identified by "H001" and the cable 9 that is identified by "C001".

### 2-3-4-2. First location data storage unit 24b-1

The first location data storage unit 24b-1 stores therein first location data. For example, the first location data storage unit 24b-1 stores therein location data L₁ that indicates the cable center position CC of the cable 9 and that is identified from the distance data D₁ by an identification unit 25b of the control unit 25 (to be described later). An example of data that is stored in the first location data storage unit 24b-1 will be described below with reference to FIG. 6. FIG. 6 is a diagram illustrating an example of the first location data storage unit 24b-1 of the current measurement apparatus 2-1 according to the first embodiment. In the example illustrated in FIG. 6, the first location data storage unit 24b-1 includes items such as a "sensor head", a "cable", and a "center position".

The "sensor head" indicates the identification information for identifying the sensor head 1-1, and is, for example, the identification number or the identification symbol of the sensor head 1-1. The "cable" indicates the identification information for identifying the cable 9 that is a conductor wire as a measurement target, and is, for example, the identification number or the identification symbol of the cable 9 on which the sensor head 1-1 is mounted. The "center position" is the location data L₁ that represents the cable center position CC of the cable 9, and is represented by, for example, three-dimensional coordinates of a point that passes through a center of a circle of the cable 9 in a cylindrical shape and that is the closest to the magnetic field sensor location MS of the magnetic field sensor 4, a distance r from the magnetic field sensor location MS, or the like.

Specifically, FIG. 6 illustrates an example in which the first location data storage unit 24b-1 stores therein data or the like including the location data L₁ of {center position: "CC001-DS"}, with respect to the sensor head 1-1 that is identified by "H001" and the cable 9 that is identified by "C001".

### 2-3-4-3. Current data storage unit 24c

The current data storage unit 24c stores therein the current data A. For example, the current data storage unit 24c stores therein the current data A that indicates the current value (A) that is calculated by a calculation unit 25c of the control unit 25 (to be described later). An example of data that is stored in the current data storage unit 24c will be described below with reference to FIG. 7. FIG. 7 is a diagram illustrating an example of the current data storage unit 24c of the current measurement apparatus 2-1 according to the first embodiment. In the example illustrated in FIG. 7, the current data storage unit 24c includes items such as a "sensor head", a "cable", a "time", a "magnetic field", and a "current".

The "sensor head" indicates the identification information for identifying the sensor head 1-1, and is, for example, the identification number or the identification symbol of the sensor head 1-1. The "cable" indicates the identification information for identifying the cable 9 that is a conductor wire as a measurement target, and is, for example, the identification number or the identification symbol of the cable 9 on which the sensor head 1-1 is mounted. The "time" indicates a time at which the current data A is output, and is represented by, for example, month-date-year, hours-minutes-seconds. The "magnetic field" indicates intensity of the magnetic field H that is generated by the current I that flows through the cable 9, and is represented by, for example, ampere per meter (A/m) or the like. The "current" indicates intensity of the current I that flows through the cable 9, and is represented by, for example, ampere (A) or the like.

Specifically, FIG. 7 illustrates an example in which the current data storage unit 24c stores therein data or the like including the current data A of {time: "T001", magnetic field: "M001", current: "A001"}, {time: "T002", magnetic field: "M002", current: "A002"}, {time: "T003", magnetic field: "M003", current: "A003"}, ..., with respect to the sensor head 1-1 that is identified by "H001" and the cable 9 that is identified by "C001".

### 2-3-5. Control unit 25

The control unit 25 controls the entire current measurement apparatus 2-1. The control unit 25 includes the acquisition unit 25a, the identification unit 25b, and the calculation unit 25c. Here, the control unit 25 may be implemented by, for example, an electronic circuit, such as a Central Processing Unit (CPU) or a Micro Processing Unit (MPU), or an integrated circuit, such as an Application Specific Integrated Circuit (ASIC) or a Field Programmable Gate Array (FPGA).

### 2-3-5-1. Acquisition unit 25a

The acquisition unit 25a acquires various kinds of information. Meanwhile, the acquisition unit 25a may store various kinds of acquired information in the storage unit 24-1. In the following, a magnetic field data acquisition process and a first detected data acquisition process will be described.

### Magnetic field data acquisition process

The acquisition unit 25a performs the magnetic field data acquisition process. For example, the acquisition unit 25a acquires a detection result of the magnetic field sensor 4. In this case, the acquisition unit 25a acquires, as the magnetic field data M that is the detection result, magnetic field intensity (A/m) or the like that is converted by the probe 5 in accordance with the sensor voltage value V1 that is detected by the magnetic field sensor 4 at the magnetic field sensor location MS.

A specific example of the magnetic field data acquisition process will be described. Firstly, the acquisition unit 25a acquires {time: "T001", magnetic field: "M001"}, {time: "T002", magnetic field: "M002"}, {time: "T003", magnetic field: "M003"}, ... as the magnetic field data M that is detected by the magnetic field sensor 4 identified by "MS001" and that is converted by the probe 5, with respect to the sensor head 1-1 that is identified by "H001" and the cable 9 that is identified by "C001". Secondly, the acquisition unit 25a stores the acquired magnetic field data M in the current data storage unit 24c.

Meanwhile, the acquisition unit 25a may acquire, as the magnetic field data M, the sensor voltage value V1 that is detected by the magnetic field sensor 4, and store the sensor voltage value V1 in the current data storage unit 24c. Further, the acquisition unit 25a may acquire, as the magnetic field data M, the sensor voltage value V1 that is detected by the magnetic field sensor 4, convert the acquired sensor voltage value V1 to the magnetic field intensity (A/m), and store the converted magnetic field intensity (A/m) in the current data storage unit 24c.

### First detected data acquisition process

The acquisition unit 25a performs the first detected data acquisition process. For example, the acquisition unit 25a acquires a detection result of a predetermined sensor. In this case, the acquisition unit 25a acquires, as the detection result, the first detected data that corresponds to a sensor value of the predetermined sensor with respect to an installation location of the cable 9 as the conductor. In this case, the predetermined sensor includes the distance sensors 6 that measure distances to the cable 9, and the acquisition unit 25a acquires, as the first detected data, a plurality of pieces of the distance data D₁ that indicate distances from the plurality of distance sensors 6 to the cable 9 and that correspond to sensor values of the respective distance sensors 6. Furthermore, the distance sensors 6 are the radar sensors 6A, and the acquisition unit 25a acquires, as the first detected data, the plurality of pieces of the distance data D₁ that indicate distances from the plurality of radar sensors 6A to the cable 9 and that correspond to sensor values of the respective radar sensors 6A. Moreover, the distance sensors 6 are the imaging sensors 6B that capture images of the cable 9, and the acquisition unit 25a acquires, as the first detected data, the plurality of pieces of the distance data D₁ that indicate distances (m) from the plurality of imaging sensors 6B to the cable 9 and that correspond to sensor values of the respective imaging sensors 6B.

A specific example of the first detected data acquisition process will be described. Firstly, with respect to the sensor head 1-1 that is identified by "H001" and the cable 9 that is identified by "C001", the acquisition unit 25a acquires "D001-DS" as the distance data D₁(1) that is detected by the distance sensor 61 that is identified by "DS001", acquires "D002-DS" as the distance data D₁(2) that is detected by a distance sensor 6-2 that is identified by "DS002", and acquires "D003-DS" as distance data D₁(3) that is detected by a distance sensor 6-3 that is identified by "DS003". Secondly, the acquisition unit 25a acquires the acquired distance data D₁(1), the acquired distance data D₁(2), and the acquired distance data D₁(3) in the first detected data storage unit 24a-1.

Meanwhile, the acquisition unit 25a may acquire, as the pieces of distance data D₁, the sensor values that are detected by the distance sensors 6, convert the acquired sensor values to distances (m), and store the converted distances (m) in the first detected data storage unit 24a-1.

### 2-3-5-2. Identification unit 25b

The identification unit 25b identifies various kinds of information. Meanwhile, the identification unit 25b may store various kinds of the identified information in the storage unit 24-1. A location data output process will be described below.

### Location data output process

The identification unit 25b performs the location data output process. For example, the cable center distance CC of the cable 9 as the conductor is identified based on the acquired detection result of the predetermined sensor. In this case, the identification unit 25b identifies the cable center position CC of the cable 9 based on the first detected data that is the detection result. Further, the identification unit 25b identifies the cable center position CC of the cable 9 based on the plurality of pieces of acquired distance data D₁.

A specific example of the location data output process will be described. Firstly, with respect to the sensor head 1-1 that is identified by "H001" and the cable 9 that is identified by "C001", the identification unit 25b refers to the distance data D₁ of {distance sensor: "DS001", distance: "D001-DS"}, {distance sensor: "DS002", distance: "D002-DS"}, {distance sensor: "DS003", distance: "D003-DS"}, ... as the first detected data that is stored in the first detected data storage unit 24a-1. Secondly, with respect to the sensor head 1-1 that is identified by "H001" and the cable 9 that is identified by "C001", the identification unit 25b refers to "CD001" that is the cable radius d of the cable 9, "L001-MS" that is the magnetic field sensor location MS of the magnetic field sensor 4, and "L001-DS", "L002-DS", "L003-DS", ... that are the distance sensor locations DS of the distance sensors 6, as setting values that are stored in the storage unit 24-1. Thirdly, with respect to the sensor head 1-1 that is identified by "H001" and the cable 9 that is identified by "C001", the identification unit 25b outputs the location data L₁ of {center position: "CC001-DS"} by using the distance data D₁, the cable radius d, the magnetic field sensor location MS of the magnetic field sensor 4, and the distance sensor locations DS of the distance sensors 6. Fourthly, the identification unit 25b stores the output location data L₁ in the first location data storage unit 24b-1.

### 2-3-5-3. Calculation unit 25c

The calculation unit 25c acquires various kinds of information. Meanwhile, the calculation unit 25c may store various kinds of the calculated information in the storage unit 24-1. A current data calculation process will be described below.

### Current data calculation process

The calculation unit 25c performs the current data calculation process. For example, the calculation unit 25c calculates, as the current data A, the current value (A) of the current I that flows through the cable 9 based on the identified cable center position CC of the cable 9 as the conductor and acquired detection result of the magnetic field sensor 4.

A specific example of the current data calculation process will be described below. Firstly, with respect to the sensor head 1-1 that is identified by "H001" and the cable 9 that is identified by "C001", the calculation unit 25c refers to the location data L₁ of {center position: "CC001-DS"} as the first location data that is stored in the first location data storage unit 24b-1, and identifies the distance r (m) from the magnetic field sensor location MS of the magnetic field sensor 4 to the cable center position CC. Secondly, with respect to the sensor head 1-1 that is identified by "H001" and the cable 9 that is identified by "C001", the calculation unit 25c acquires {time: "T001", magnetic field: "M001"}, {time: "T002", magnetic field: "M002"}, {time: "T003", magnetic field: "M003"}, ... that are the magnetic field data M that is stored in the current data storage unit 24c. Thirdly, the calculation unit 25c calculates the current data A of {time: "T001", current: "A001"}, {time: "T002", current: "A002"}, {time: "T003", current: "A003"}, ... by assigning the distance r (m) and the magnetic field intensity (A/m) indicated by the magnetic field data M to Expression of H=I/(2πr) that is derived by the Ampere's circuital law. Fourthly, the calculation unit 25c stores the calculated current data A in the current data storage unit 24c.

### 2-4. Configuration example and process example of probe 5

A configuration example and a process example of the probe 5 will be described with reference to FIG. 4. The probe 5 includes the detection circuit 51 and converts a detection result of the magnetic field sensor 4. For example, the probe 5 converts the sensor voltage value V1 that is detected by the magnetic field sensor 4 to the magnetic field intensity (A/m).

### 2-5. Configuration example and process example of distance sensor 6

A configuration example and a process example of the distance sensors 6 will be described with reference to FIG. 4. The distance sensor 6 are examples of the predetermined sensors that detect the cable 9 as the conductor. For example, the distance sensors 6 measure distances to the cable 9. In this case, the distance sensors 6 include the radar sensor 6A. Further, the distance sensors 6 include the imaging sensor 6B that captures an image of the cable 9.

### 3. Flow of each of processes of current measurement system 100-1

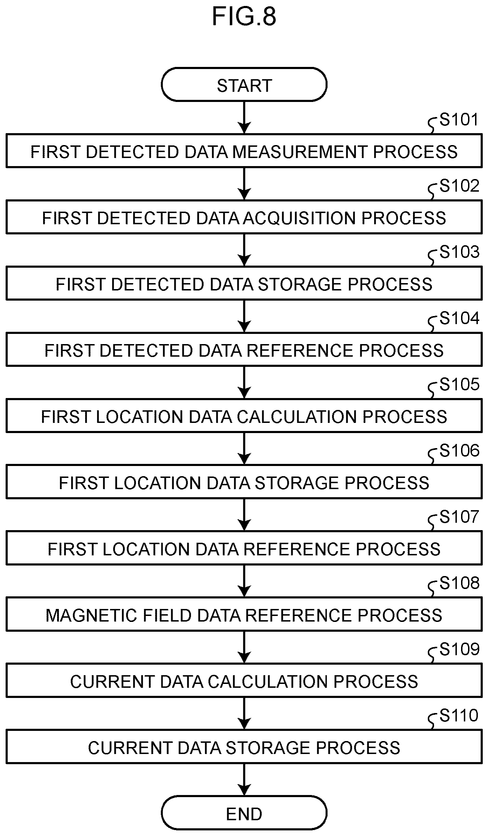

A flow of processes performed by the current measurement system 100-1 according to the first embodiment will be described with reference to FIG. 8. FIG. 8 is a flowchart illustrating an example of the flow of processes of the current measurement system 100-1 according to the first embodiment. Meanwhile, processes from Step S101 to Step S110 below may be performed in different order. Further, some of the processes from Step S101 to Step S110 below may be omitted.

### 3-1. First detected data measurement process

Firstly, the current measurement system 100-1 performs a first detected data measurement process (Step S101). For example, the distance sensor 61 outputs, as the first detected data, the distance data D₁(1) that indicates a distance from the distance sensor 61 to the surface of the cable 9. Further, the distance sensor 62 outputs, as the first detected data, the distance data D₁(2) that indicates a distance from the distance sensor 62 to the surface of the cable 9.

### 3-2. First detected data acquisition process

Secondly, the current measurement system 100-1 performs the first detected data acquisition process (Step S102). For example, the current measurement apparatus 2-1 acquires, as the first detected data, the distance data D₁(1) from the distance sensor 61. Further, the current measurement apparatus 2-1 acquires, as the first detected data, the distance data D₁(2) from the distance sensor 62.

### 3-3. First detected data storage process

Thirdly, the current measurement system 100-1 performs a first detected data storage process (Step S103). For example, the current measurement apparatus 2-1 stores, as the first detected data, the distance data D₁(1) that is acquired from the distance sensor 61 and the distance data D₁(2) that is acquired from the distance sensor 62 in the first detected data storage unit 24a-1.

### 3-4. First detected data reference process

Fourthly, the current measurement system 100-1 performs a first detected data reference process (Step S104). For example, the current measurement apparatus 2-1 refers to, as the first detected data, the distance data D₁(1) and the distance data D₁(2) that are stored in the first detected data storage unit 24a-1. Further, the current measurement apparatus 2-1 refers to the cable radius d of the cable 9 that is the setting value that is stored in the storage unit 24-1. Furthermore, the current measurement apparatus 2-1 refers to the magnetic field sensor location MS of the magnetic field sensor 4 that is the setting value that is stored in the storage unit 24-1. Moreover, the current measurement apparatus 2-1 refers to a distance sensor location DS-1 of the distance sensor 61 and a distance sensor location DS-2 of the distance sensor 62 that are the setting values that are stored in the storage unit 24-1.

### 3-5. First location data calculation process

Fifthly, the current measurement system 100-1 performs a first location data calculation process (Step S105). For example, the current measurement apparatus 2-1 calculates, as the first location data, the location data L₁ that indicates the cable center position CC of the cable 9 by using the distance data D₁(1), the distance data D₁(2), the cable radius d, the magnetic field sensor location MS, the distance sensor location DS-1, and the distance sensor location DS-2.

### 3-6. First location data storage process

Sixthly, the current measurement system 100-1 performs a first location data storage process (Step S106). For example, the current measurement apparatus 2-1 stores, as the first location data, three coordinates of the calculated cable center position CC or the location data L₁ including the distance r from the magnetic field sensor location MS in the first location data storage unit 24b-1.

### 3-7. First location data reference process

Seventhly, the current measurement system 100-1 performs a first location data reference process (Step S107). For example, the current measurement apparatus 2-1 refers to, as the first location data, the location data L₁ that is stored in the first location data storage unit 24b-1.

### 3-8. Magnetic field data reference process

Eighthly, the current measurement system 100-1 performs a magnetic field data reference process (Step S108). For example, the current measurement apparatus 2-1 refers to the magnetic field data M that is measured by the magnetic field sensor 4 and that is stored in the current data storage unit 24c.

### 3-9. Current data calculation process

Ninthly, the current measurement system 100-1 performs a current data calculation process (Step S109). For example, the current measurement apparatus 2-1 calculates the current data A that indicates the current value (A) of the current I that flows through the cable 9 by using the location data L₁ and the magnetic field data M at regular time intervals.

### 3-10. Current data storage process

Tenthly, the current measurement system 100-1 performs a current data storage process (Step S110), and terminates the process. For example, the current measurement apparatus 2-1 stores the calculated current data A in the current data storage unit 24c. In this case, the current measurement apparatus 2-1 may display the calculated current data A as a waveform of the current I on the output unit 22 that is a display.

### 4. Effects of first embodiment

Effects of the first embodiment will be described. In the following, a first effect to a third effect corresponding to the processes according to the first embodiment will be described.

### 4-1. First effect

Firstly, in the process according to the first embodiment as described above, the current measurement system 100-1 includes the magnetic field shield 3 that is configured to capture, to the inside thereof, the magnetic field H that is generated by the current I that flows through the cable 9, the magnetic field sensor 4 that is installed inside the magnetic field shield 3, the distance sensors 6 that measure distances to the cable 9, and the current measurement apparatus 2-1. The current measurement apparatus 2-1 acquires detection results of the distance sensors 6 and a detection result of the magnetic field sensor 4, identifies the cable center position CC of the cable 9 based on the acquired detection results of the distance sensors 6, and calculates the current value (A) of the current I that flows through the cable 9 based on the identified cable center position CC and the acquired detection result of the magnetic field sensor 4. Therefore, in this process, by using the distance sensors 6 as the predetermined sensors for detecting the cable 9, it is possible to improve measurement accuracy of the current I that flows through the cable 9.

### 4-2. Second effect

Secondly, in the process according to the first embodiment as described above, the distance sensors 6 include the radar sensor 6A. Therefore, in this process, by using the radar sensor 6A as the predetermined sensor for detecting the cable 9, it is possible to improve measurement accuracy of the current I that flows through the cable 9.

### 4-3. Third effect

Thirdly, in the process according to the first embodiment as described above, the distance sensors 6 include the imaging sensor 6B that captures an image of the cable 9. Therefore, in this process, by using the imaging sensor 6B as the predetermined sensor for detecting the cable 9, it is possible to improve measurement accuracy of the current I that flows through the cable 9.

### Second embodiment

A configuration and a process of a current measurement system 100-2 according to a second embodiment, a configuration and a process of each of apparatuses of the current measurement system 100-2, the flow of each of processes of the current measurement system 100-2, effects of the second embodiment will be described below. Meanwhile, explanation of the same configurations and the same processes as those of the first embodiment will be omitted.

### 1. Configuration and process of current measurement system 100-2

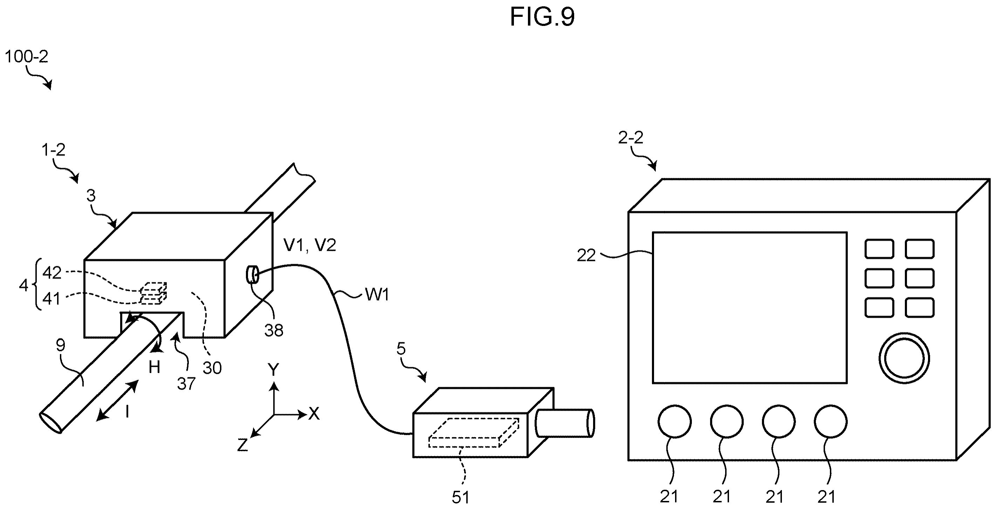

A configuration and a process of the current measurement system 100-2 according to the second embodiment will be described with reference to FIG. 9. In the following, a configuration example of the entire current measurement system 100-2, a configuration example of a sensor head 1-2, a process example of the current measurement system 100-2, and effects of the current measurement system 100-2 will be described below. Meanwhile, a configuration example of the magnetic field shield 3 and a configuration example of the cable 9 are the same as those of the first embodiment, and therefore, explanation thereof will be omitted.

### 1-1. Configuration example of entire current measurement system 100-2

A configuration example of the entire current measurement system 100-2 will be described with reference to FIG. 9. The current measurement system 100-2 includes the sensor head 1-2, a current measurement apparatus 2-2, and the probe 5. FIG. 9 is a diagram illustrating a configuration example and a process example of the current measurement system 100-2 according to the second embodiment. Here, the sensor head 1-2, the current measurement apparatus 2-2, and the probe 5 are communicably connected to one another in a wired or wireless manner via a predetermined communication network. Meanwhile, as the predetermined communication network, it is possible to adopt various kinds of communication networks, such as the Internet or a dedicated line.

### 1-1-1. Sensor head 1-2

The sensor head 1-2 is a sensor device that is installed in the cable 9 that is a conductor as a measurement target, and measures the magnetic field H that is generated by the current I that flows through the cable 9. The sensor head 1-2 is covered by the magnetic field shield 3 that has a partly-opened bottom surface, and the plurality of magnetic field sensors 4 (41, 42) are arranged inside the sensor head 1-2. Meanwhile, the current measurement system 100-2 illustrated in FIG. 9 may include the plurality of sensor heads 1-2. Meanwhile, the direction of the current I, the direction of the magnetic field, and the XYZ coordinate system are the same as those of the first embodiment, and therefore, explanation thereof will be omitted.

The magnetic field shield 3 captures (a part of) the magnetic field H that is generated by the current I that flows through the cable 9 into the internal space 30 via the opening portion 37. Further, the magnetic field sensor 41 detects the magnetic field H that is captured into the internal space 30 of the magnetic field shield 3 and outputs the magnetic field H as the sensor voltage value V1. Further, the magnetic field sensor 42 detects the magnetic field H that is captured into the internal space 30 of the magnetic field shield 3 and outputs the magnetic field H as a sensor voltage value V2. In this case, the magnetic field sensors 4 output the sensor voltage values V1 and V2 to the detection circuit 51 that is incorporated in the probe 5, via the terminal 38 of the magnetic field shield 3 and the wiring W1.

### 1-1-2. Current measurement apparatus 2-2

The current measurement apparatus 2-2 is an apparatus that identifies the cable center position CC of the cable 9 and measures the current I that flows through the cable 9. Meanwhile, the current measurement system 100-2 illustrated in FIG. 9 may include the plurality of current measurement apparatuses 2-2. Further, in the example illustrated in FIG. 9, a case is illustrated in which the current measurement apparatus 2-2 is implemented by an oscilloscope, but the current measurement apparatus 2-2 may be implemented by a desktop PC, a notebook PC, a smartphone, a server apparatus, a cloud system, or the like.

The current measurement apparatus 2-2 includes the input unit 21 and the output unit 22. In the example illustrated in FIG. 9, the input unit 21 is an input terminal and connected to the probe 5. Further, the output unit 22 is a display and displays a waveform of the measured current I.

### 1-1-3. Probe 5

The probe 5 is a device that is communicably connected between the sensor head 1-2 and the current measurement apparatus 2-2 by the wiring W1 and incorporates therein the detection circuit 51 that converts the sensor voltage values V1 and V2 that are detected by the sensor head 1-2. Meanwhile, the current measurement system 100-2 illustrated in FIG. 9 may include the plurality of probes 5. Further, the probe 5 may be integrated with the current measurement apparatus 2-2 or the sensor head 1-2.

### 1-2. Configuration example of the sensor head 1-2

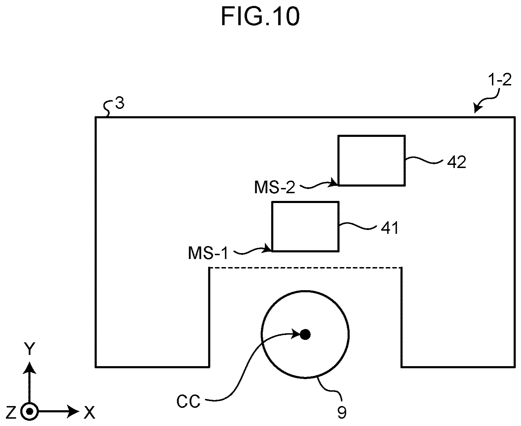

A configuration example of the sensor head 1-2 will be described with reference to FIG. 10. FIG. 10 is a diagram illustrating a configuration example of the sensor head 1-2 according to the second embodiment. The sensor head 1-2 includes the magnetic field shield 3, the magnetic field sensor 41, and the magnetic field sensor 42. In the example illustrated in FIG. 10, the sensor head 1-2 is mounted on the cable 9 so as to pass through the opening portion 37 below the magnetic field sensors 4. In this case, the sensor head 1-2 may use, for example, a hook-shaped member, a ring-shaped member or the like for mounting the magnetic field shield 3 on the cable 9, or a spring member for fixing the mounted state. Further, the sensor head 1-2 may include the magnetic field sensor 41 inside the magnetic field shield 3 such that the magnetic field sensor 41 is located in the vertical direction of the cable 9, or may include the magnetic field sensor 42 inside the magnetic field shield 3 such that the magnetic field sensor 42 is located so as to deviate from the vertical direction of the cable 9, but the installation locations of the magnetic field sensors 4 are not specifically limited. In the following explanation, in the XZ plane direction of the sensor head 1-2, an installation location of the magnetic field sensor 41 is referred to as a magnetic field sensor location MS-1, and an installation location of the magnetic field sensor 42 is referred to as a magnetic field sensor location MS-2. Furthermore, a center of the cable 9 in the XY plane direction located closest to the magnetic field sensor location MS-1 or the magnetic field sensor location MS-2 is referred to as the cable center position CC.

### 1-3. Process example of current measurement system 100-2

A process example of the current measurement system 100-2 will be described. In the following, a distance data measurement process, a distance data acquisition process, a cable center position identification process, and a current data calculation process will be described. Meanwhile, the processes as described above may be performed in a different order. Further, any of the processes as described above may be omitted.

### 1-3-1. Distance data measurement process

Firstly, the sensor head 1-2 measures distance data D₂ with respect to the cable 9. In this case, the sensor head 1-2 measures the distance data D₂ that indicates distances between the magnetic field sensor locations MS and the cable center position CC and that corresponds to the magnetic field data M detected by the magnetic field sensors 4. For example, the sensor head 1-2 causes the detection circuit 51 of the probe 5 to convert the sensor voltage value V1 that is detected by the magnetic field sensor 41, and outputs distance data D₂(1) that indicates a distance between the magnetic field sensor location MS-1 and the cable center position CC of the cable 9. Further, the sensor head 1-2 causes the detection circuit 51 of the probe 5 to convert the sensor voltage value V2 that is detected by the magnetic field sensor 42, and outputs distance data D₂(2) that indicates a distance between the magnetic field sensor location MS-2 and the cable center position CC of the cable 9.

### 1-3-2. Distance data acquisition process

Secondly, the current measurement apparatus 2-2 acquires the distance data D₂ from the sensor head 1-2. For example, the current measurement apparatus 2-2 acquires the distance data D₂(1) that corresponds to the detection result of the magnetic field sensor 41 from the sensor head 1-2 via the probe 5. Further, the current measurement apparatus 2-2 acquires the distance data D₂(2) that corresponds to the detection result of the magnetic field sensor 42 from the sensor head 1-2 via the probe 5.

### 1-3-3. Cable center position identification process

Thirdly, the current measurement apparatus 2-2 identifies the cable center position CC of the cable 9. For example, the current measurement apparatus 2-2 identifies the cable center position CC of the cable 9 by using the distance data D₂(1) that corresponds to the detection result of the magnetic field sensor 41 and the distance data D₂(2) that corresponds to the detection result of the magnetic field sensor 42. In this case, the current measurement apparatus 2-2 identifies the cable center position CC by using the magnetic field sensor location MS-1 of the magnetic field sensor 41 and the magnetic field sensor location MS-2 of the magnetic field sensor 42 that are setting values.

### 1-3-4. Current data calculation process

Fourthly, the current measurement apparatus 2-2 calculates the current data A of the current I that flows through the cable 9. For example, the current measurement apparatus 2-2 calculates the current data A that indicates the current value (A) of the current I that flows through the cable 9 at regular time intervals by using the identified cable center position CC of the cable 9, the magnetic field sensor locations MS as setting values of the magnetic field sensors 4, and the magnetic field data M acquired from the magnetic field sensors 4. In this case, the current measurement apparatus 2-2 is able to calculate the current data A by using the magnetic field data M that is acquired from the arbitrary magnetic field sensor 4 among the plurality of magnetic field sensors 4 (41, 42).

### 1-4. Effect of current measurement system 100-2

An overview of the current measurement system 100-2 according to the second embodiment will be first described, and thereafter, an effect of the current measurement system 100-2 will be described.

### 1-4-1. Overview of current measurement system 100-2

An overview of the current measurement system 100-2 according to the second embodiment will be described. The current measurement system 100-2 performs processes as described below. Firstly, the sensor head 1-2 measures the distance data D₂ that indicates the distance to the cable 9 via the plurality of magnetic field sensors 4 (41, 42, ...). Secondly, the current measurement apparatus 2-2 acquires the distance data D₂ from the sensor head 1-2. Thirdly, the current measurement apparatus 2-2 identifies the cable center position CC of the cable 9 by using the distance data D₂. Fourthly, the current measurement apparatus 2-2 calculates the current data A that indicates the current value (A) of the current I that flows through the cable 9 by using the cable center position CC and the magnetic field data M.

### 1-4-2. Effect of current measurement system 100-2

An effect of the current measurement system 100-2 according to the second embodiment will be described. The current measurement system 100-2 collects the distance data D₂ of the distance to the cable 9 by the plurality of magnetic field sensors 4 that are installed inside the sensor head 1-2, and accurately identifies the cable center position CC for calculating the current value (A) of the current I that flows through the cable 9. Therefore, the current measurement system 100-2 is able to improve measurement accuracy of the current I that flows through the cable 9.

### 2. Configuration and process of each of apparatuses of current measurement system 100-2

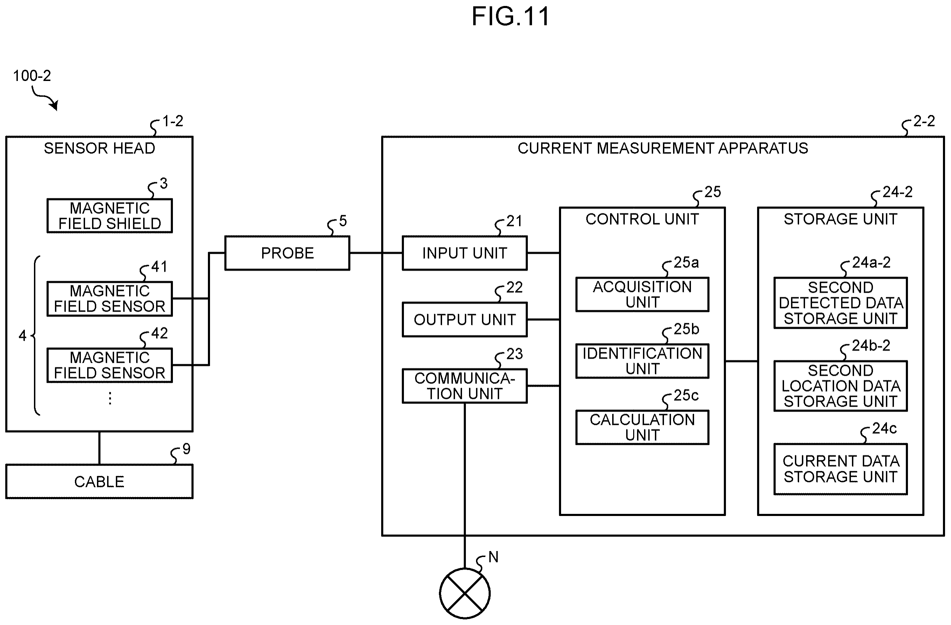

A configuration and a process of each of apparatuses included in the current measurement system 100-2 illustrated in FIG. 10 will be described with reference to FIG. 11 to FIG. 13. In the following, a configuration example of the entire current measurement system 100-2 according to the second embodiment, a configuration example and a process example of the sensor head 1-2, a configuration example and a process example of the current measurement apparatus 2-2, and a configuration example and a process example the probe 5 will be described.

### 2-1. Configuration example of entire current measurement system 100-2

A configuration example of the entire current measurement system 100-2 illustrated in FIG. 10 will be described with reference to FIG. 11. FIG. 11 is a block diagram illustrating a configuration example of each of apparatuses of the current measurement system 100-2 according to the second embodiment. As illustrated in FIG. 11, the current measurement system 100-2 includes the sensor head 1-2, the current measurement apparatus 2-2, and the probe 5. Further, the sensor head 1-2 and the current measurement apparatus 2-2 are communicably connected to each other by a dedicated line or the like via the probe 5. Furthermore, the current measurement apparatus 2-2 is communicably connected by the communication network N that is implemented by the Internet, a dedicated line, or the like.

### 2-2. Configuration example and process example of sensor head 1-2

A configuration example and a process example of the sensor head 1-2 will be described with reference to FIG. 11. As illustrated in FIG. 11, the sensor head 1-2 includes the magnetic field shield 3 and the plurality of magnetic field sensors 4 (41, 42, ...) and is installed in the cable 9 as the conductor.

### 2-2-1. Magnetic field shield 3

The magnetic field shield 3 is configured to capture, to the inside thereof, the magnetic field H that is generated by the current I that flows through the cable 9. Further, the magnetic field shield 3 is configured to shield the magnetic field H. The magnetic field shield 3 may be made by using various kinds of well-known materials, such as a metal material.

### 2-2-2. Magnetic field sensors 4

The magnetic field sensors 4 are examples of the predetermined sensors that detect the cable 9. The magnetic field sensors 4 are installed inside the magnetic field shield 3. Further, the magnetic field sensors 4 detect the magnetic fields H at the magnetic field sensor locations MS that are the installation locations. Furthermore, the magnetic field sensors 4 include the plurality of magnetic field sensors 4 (41, 42, ...) that are installed at different locations. For example, the magnetic field sensor 4 is an IC sensor that includes a Hall element, and may be referred to as an analog Hall IC or the like. Moreover, the magnetic field sensor 4 may be a coil sensor that includes a coil. In this case, it may be possible to use a Rogowski coil as the magnetic field sensor 4, which enables downsizing and makes it possible to easily arrange the magnetic field sensor 4 in the magnetic field shield 3.

### 2-3. Configuration example and process example of current measurement apparatus 2-2

A configuration example and a process example of the current measurement apparatus 2-2 will be described with reference to FIG. 11. As illustrated in FIG. 11, the current measurement apparatus 2-2 includes the input unit 21, the output unit 22, the communication unit 23, a storage unit 24-2, and a control unit 25. Meanwhile, the input unit 21, the output unit 22, and the communication unit 23 are the same as those of the first embodiment, and therefore, explanation thereof will be omitted.

### 2-3-1. Storage unit 24-2

The storage unit 24-2 stores therein various kinds of information that are referred to when the control unit 25 operates and various kinds of information that are acquired when the control unit 25 operates. The storage unit 24-2 includes a second detected data storage unit 24a-2, a second location data storage unit 24b-2, and the current data storage unit 24c. Here, the storage unit 24-2 may be implemented by, for example, a semiconductor memory device, such as a RAM or a flash memory, a storage device, such as a hard disk or an optical disk, or the like. Meanwhile, in the example illustrated in FIG. 11, the storage unit 24-2 is installed inside the current measurement apparatus 2-2, but the storage unit 24-2 may be installed outside the current measurement apparatus 2-2 or it may be possible to install a plurality of storage units. Further, the current data storage unit 24c is the same as the first embodiment, and therefore, explanation thereof will be omitted.

### 2-3-1-1. Second detected data storage unit 24a-2

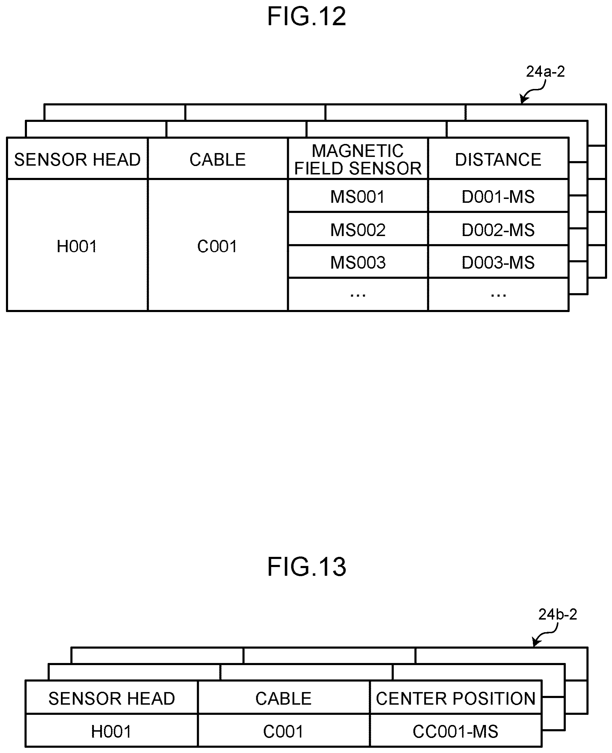

The second detected data storage unit 24a-2 stores therein second detected data. For example, the second detected data storage unit 24a-2 stores therein, as the second detected data, the distance data D₂ that correspond to sensor values detected by the magnetic field sensors 4 and that are acquired by the acquisition unit 25a of the control unit 25 (to be described later). An example of data that is stored in the second detected data storage unit 24a-2 will be described below with reference to FIG. 12. FIG. 12 is a diagram illustrating an example of the second detected data storage unit 24a-2 the current measurement apparatus 2-2 according to the second embodiment. In the example illustrated in FIG. 12, the second detected data storage unit 24a-2 includes items such as a "sensor head", a "cable", a "magnetic field sensor", and a "distance".

The "sensor head" indicates identification information for identifying the sensor head 1-2, and is, for example, an identification number or an identification symbol of the sensor head 1-2. The "cable" indicates the identification information for identifying the cable 9 that is a conductor wire as a measurement target, and is, for example, the identification number or the identification symbol of the cable 9 on which the sensor head 1-2 is mounted. The "magnetic field sensor" indicates identification information for identifying the magnetic field sensor 4, and is, for example, an identification number or an identification symbol of the magnetic field sensor 4. The "distance" is the distance data D₂ between the magnetic field sensor 4 and the center of the cable 9, and is represented by, for example, millimeters (mm), centimeters (cm), meters (m), or the like.

Specifically, FIG. 12 illustrates an example in which the second detected data storage unit 24a-2 stores therein data or the like including the distance data D₂ of {magnetic field sensor: "MS001", distance: "D001-MS"}, {magnetic field sensor: "MS002", distance: "D002-MS"}, {magnetic field sensor: "MS003", distance: "D003-MS"}, ..., with respect to the sensor head 1-2 that is identified by "H001" and the cable 9 that is identified by "C001".

### 2-3-1-2. Second location data storage unit 24b-2

The second location data storage unit 24b-2 stores therein second location data. For example, the second location data storage unit 24b-2 stores therein location data L₂ that indicates the cable center position CC of the cable 9 and that is identified from the distance data D₂ by the identification unit 25b of the control unit 25 (to be described later). An example of data that is stored in the second location data storage unit 24b-2 will be described below with reference to FIG. 13. FIG. 13 is a diagram illustrating an example of the second location data storage unit 24b-2 of the current measurement apparatus 2-2 according to the present embodiment. In the example illustrated in FIG. 13, the second location data storage unit 24b-2 includes items such as a "sensor head", a "cable", and a "center position".

The "sensor head" indicates the identification information for identifying the sensor head 1-2, and is, for example, the identification number or the identification symbol of the sensor head 1-2. The "cable" indicates the identification information for identifying the cable 9 that is a conductor wire as a measurement target, and is, for example, the identification number or the identification symbol of the cable 9 on which the sensor head 1-2 is mounted. The "center position" is the location data L₂ that represents the cable center position CC of the cable 9, and is represented by, for example, three-dimensional coordinates of a point that passes through the center of the circle of the cable 9 in a cylindrical shape and that is the closest to the magnetic field sensor location MS of the magnetic field sensor 4, the distance r from the magnetic field sensor location MS, or the like.

Specifically, FIG. 13 illustrates an example in which the second location data storage unit 24b-2 stores therein data or the like including the location data L₂ of {center position: "CC001-MS"}, with respect to the sensor head 1-2 that is identified by "H001" and the cable 9 that is identified by "C001".

### 2-3-2. Control unit 25

The control unit 25 controls the entire current measurement apparatus 2-2. The control unit 25 includes the acquisition unit 25a, the identification unit 25b, and the calculation unit 25c. Here, the control unit 25 may be implemented by, for example, an electronic circuit, such as a CPU or an MPU, or an integrated circuit, such as an ASIC or an FPGA.

### 2-3-2-1. Acquisition unit 25a

The acquisition unit 25a acquires various kinds of information. Meanwhile, the acquisition unit 25a may store various kinds of acquired information in the storage unit 24-2. In the following, a magnetic field data acquisition process and a second detected data acquisition process will be described.

### Magnetic field data acquisition process

The acquisition unit 25a performs the magnetic field data acquisition process. For example, the acquisition unit 25a acquires detection results of the magnetic field sensors 4. In this case, the acquisition unit 25a acquires, as the magnetic field data M that is the detection result, magnetic field intensity (A/m) or the like that is converted by the probe 5 in accordance with the sensor voltage value V1 that is detected by the magnetic field sensor 41 at the magnetic field sensor location MS.

A specific example of the magnetic field data acquisition process will be described. Firstly, the acquisition unit 25a acquires {time: "T001", magnetic field: "M001"}, {time: "T002", magnetic field: "M002"}, {time: "T003", magnetic field: "M003"}, ... as the magnetic field data M that is detected by the magnetic field sensor 41 identified by "MS001" and that is converted by the probe 5, with respect to the sensor head 1-2 that is identified by "H001" and the cable 9 that is identified by "C001". Secondly, the acquisition unit 25a stores the acquired magnetic field data M in the current data storage unit 24c.

Meanwhile, the acquisition unit 25a may acquire, as the magnetic field data M, the sensor voltage value V1 that is detected by the magnetic field sensor 41, and store the sensor voltage value V1 in the current data storage unit 24c. Further, the acquisition unit 25a may acquire, as the magnetic field data M, the sensor voltage value V1 that is detected by the magnetic field sensor 41, convert the acquired sensor voltage value V1 to the magnetic field intensity (A/m), and store the converted magnetic field intensity (A/m) in the current data storage unit 24c.

### Second detected data acquisition process

The acquisition unit 25a performs the second detected data acquisition process. For example, the acquisition unit 25a acquires, as the second detected data, a detection result of a predetermined sensor. In this case, the predetermined sensor includes the plurality of magnetic field sensors 4 (41, 42, ...), and the acquisition unit 25a acquires, as the detection result of the predetermined sensor, a detection result of each of the magnetic field sensors 4 (41, 42, ...). Furthermore, the acquisition unit 25a acquires a plurality of pieces of the distance data D₂ that indicate distances (m) from the plurality of magnetic field sensors 4 (41, 42, ...) to the cable 9 and that are converted by the probe 5 in accordance with sensor values of the respective magnetic field sensors 4 (41, 42, ...).

A specific example of the second detected data acquisition process will be described. Firstly, with respect to the sensor head 1-2 that is identified by "H001" and the cable 9 that is identified by "C001", the acquisition unit 25a acquires "D001-MS" as distance data D₂(1) that is detected by the magnetic field sensor 41 identified by "MS001" and that is converted by the probe 5, acquires "D002-MS" as the distance data D₂(2) that is detected by the magnetic field sensor 42 identified by "DS002" and that is converted by the probe 5, and acquires "D003-MS" as distance data D₂(3) that is detected by a magnetic field sensor 43 identified by "MS003" and that is converted by the probe 5. Secondly, the acquisition unit 25a stores the acquired distance data D₂(1), the acquired distance data D₂(2), and the acquired distance data D₂(3) in the second detected data storage unit 24a-2.

Meanwhile, the acquisition unit 25a may acquire, as the distance data D₂, the sensor voltage values V1, V2, ... that are detected by the plurality of magnetic field sensors 4 (41, 42, ...), and store the acquired sensor values in the second detected data storage unit 24a-2. Furthermore, the acquisition unit 25a may acquire, as the distance data D₂, the sensor voltage values V1, V2, ... that are detected by the plurality of magnetic field sensors 4 (41, 42, ...), convert the acquired sensor voltage values V1, V2, ... to distances (m), and store the converted distances (m) in the second detected data storage unit 24a-2.

### 2-3-2-2. Identification unit 25b

The identification unit 25b identifies various kinds of information. Meanwhile, the identification unit 25b may store various kinds of the identified information in the storage unit 24-2. A location data output process will be described below.

### Location data output process

The identification unit 25b performs the location data output process. For example, the identification unit 25b identifies the cable center position CC of the cable 9 as the conductor by using the acquired detection result (second detected data) of each of the magnetic field sensors 4 (41, 42, ...). In this case, the identification unit 25b identifies the cable center position CC of the cable 9 by using the plurality of pieces of acquired distance data D₂.

A specific example of the location data output process will be described. Firstly, with respect to the sensor head 1-2 that is identified by "H001" and the cable 9 that is identified by "C001", the identification unit 25b refers to the distance data D₂ of {magnetic field sensor: "MS001", distance: "D001-MS"}, and {magnetic field sensor: "MS002", distance: "D002-MS"} as second detected data that is stored in the second detected data storage unit 24a-2. Secondly, with respect to the sensor head 1-2 that is identified by "H001" and the cable 9 that is identified by "C001", the identification unit 25b refers to "L001-MS" that is the magnetic field sensor location MS-1 of the magnetic field sensor 41 and "L002-MS" that is the magnetic field sensor location MS-2 of the magnetic field sensor 42, as setting values that are stored in the storage unit 24-2. Thirdly, with respect to the sensor head 1-2 that is identified by "H001" and the cable 9 that is identified by "C001", the identification unit 25b identifies, as the cable center position CC of the cable 9, an intersection of two circles, one of which is an exact circle with a center of "L001-MS" and a radius of "D001-MS" on the XY plane, and the other one of which is an exact circle with a center of "L002-MS" and a radius of D002-MS" on the XY plane, and outputs the location data L₂ of {center position: "CC001-MS"}. Fourthly, the identification unit 25b stores the output location data L₂ in the second location data storage unit 24b-2.

### 2-3-2-3. Calculation unit 25c

The calculation unit 25c acquires various kinds of information. Meanwhile, the calculation unit 25c may store various kinds of the calculated information in the storage unit 24-2. A current data calculation process will be described below.

### Current data calculation process

The calculation unit 25c performs the current data calculation process. For example, the calculation unit 25c calculates, as the current data A, the current value (A) of the current I that flows through the cable 9 based on the identified cable center position CC of the cable 9 as the conductor and acquired detection result of the magnetic field sensor 4. In this case, the calculation unit 25c calculates the current value (A) of the current I that flows through the cable 9 based on the detection result of at least the single magnetic field sensor 4 among the plurality of magnetic field sensors 4 (41, 42, ...) and the identified cable center position CC of the cable 9.

A specific example of the current data calculation process will be described below. Firstly, with respect to the sensor head 1-2 that is identified by "H001" and the cable 9 that is identified by "C001", the calculation unit 25c refers to the location data L₂ of {center position: "CC001-MS"} as the second location data that is stored in the second location data storage unit 24b-2, and identifies the distance r (m) from the magnetic field sensor location MS-1 of the magnetic field sensor 41 to the cable center position CC. Secondly, with respect to the sensor head 1-2 that is identified by "H001" and the cable 9 that is identified by "C001", the calculation unit 25c acquires {time: "T001", magnetic field: "M001"}, {time: "T002", magnetic field: "M002"}, {time: "T003", magnetic field: "M003"}, ... as the magnetic field data M that is stored in the current data storage unit 24c. Thirdly, the calculation unit 25c calculates the current data A of {time: "T001", current: "A001"}, {time: "T002", current: "A002"}, {time: "T003", current: "A003"}, ... by assigning the distance r (m) and the magnetic field intensity (A/m) indicated by the magnetic field data M to Expression of H=I/(2πr) that is derived by the Ampere's circuital law. Fourthly, the calculation unit 25c stores the calculated current data A in the current data storage unit 24c.

Furthermore, the calculation unit 25c may use only the magnetic field data M that is acquired from the designated magnetic field sensor 4 for the current data calculation process, or use the magnetic field data M that is acquired from the plurality of magnetic field sensors 4 (41, 42, ...) that have output the distance data D₂ for the current data calculation process. Specifically, it may be possible to use any data among the pieces of magnetic field data M, such as the plurality of sensor voltage values V1, V2, ..., that are output from the plurality of magnetic field sensors 4 (41, 42, ...) for calculation of the distance data D₂ or for calculation of the current data A. Moreover, the calculation unit 25c may use the distance data D₁ that is output from the distance sensor 6 according to the first embodiment.

### 2-4. Configuration example and process example of probe 5

A configuration example and a process example of the probe 5 will be described with reference to FIG. 11. The probe 5 includes the detection circuit 51 and converts a detection result of the magnetic field sensor 4. For example, the probe 5 converts the sensor voltage values V1, V2, ... that are detected by the plurality of magnetic field sensors 4 (41, 42, ...) to the magnetic field intensities (A/m).

The probe 5 converts the sensor voltage values V1, V2, ... that are detected by the plurality of magnetic field sensors 4 (41, 42, ...) to the distance data D₂. For example, the probe 5 performs conversion to the distance data D₂ by assigning the magnetic field intensity (A/m) of the magnetic field H that is generated when the current I for which a current amount (A) is a constant value flows through the cable 9 to Expression of H=I/(2πr) that is derived by the Ampere's circuital law.

### 3. Flow of each of processes of current measurement system 100-2

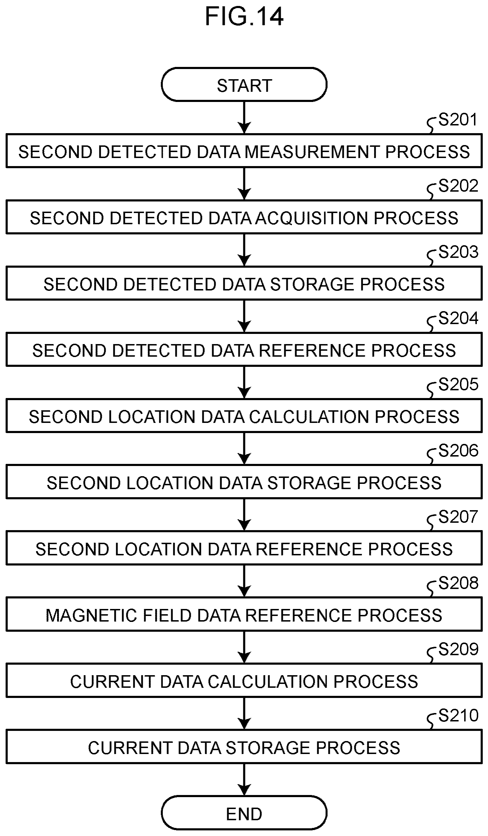

A flow of processes performed by the current measurement system 100-2 according to the second embodiment will be described with reference to FIG. 14. FIG. 14 is a flowchart illustrating an example of the flow of processes of the current measurement system 100-2 according to the second embodiment. Meanwhile, processes from Step S201 to Step S210 below may be performed in different order. Further, some of the processes from Step S201 to Step S210 below may be omitted.

### 3-1. Second detected data measurement process

Firstly, the current measurement system 100-2 performs a second detected data measurement process (Step S201). For example, the sensor head 1-2 outputs, as the second detected data, the sensor voltage value V1 that corresponds to the magnetic field H of the magnetic field sensor location MS-1 of the magnetic field sensor 41. Further, the sensor head 1-2 outputs, as the second detected data, the sensor voltage value V2 that corresponds to the magnetic field H of the magnetic field sensor location MS-2 of the magnetic field sensor 42.

### 3-2. Second detected data acquisition process

Secondly, the current measurement system 100-2 performs the second detected data acquisition process (Step S202). For example, the current measurement apparatus 2-2 acquires, as the second detected data, the distance data D₂(1) that is obtained by converting the sensor voltage value V1 detected by the magnetic field sensor 41 to a distance (m) from the magnetic field sensor 41 to the center of the cable 9 by the probe 5. Further, the current measurement apparatus 2-2 acquires, as the second detected data, the distance data D₂(2) that is obtained by converting the sensor voltage value V2 detected by the magnetic field sensor 42 to a distance (m) from the magnetic field sensor 42 to the center of the cable 9 by the probe 5.

### 3-3. Second detected data storage process

Thirdly, the current measurement system 100-2 performs a second detected data storage process (Step S203). For example, the current measurement apparatus 2-2 stores, as the second detected data, the distance data D₁(1) and the distance data D₁(2) that are acquired from the sensor head 1-2 in the second detected data storage unit 24a-2.

### 3-4. Second detected data reference process

Fourthly, the current measurement system 100-2 performs a second detected data reference process (Step S204). For example, the current measurement apparatus 2-2 refers to, as the second detected data, the distance data D₁(1) and the distance data D₁(2) that are stored in the second detected data storage unit 24a-2. Further, the current measurement apparatus 2-2 refers to the magnetic field sensor location MS-1 of the magnetic field sensor 41 and the magnetic field sensor location MS-2 of the magnetic field sensor 42 that are the setting values that are stored in the storage unit 24-2.

### 3-5. Second location data calculation process

Fifthly, the current measurement system 100-2 performs a second location data calculation process (Step S205). For example, the current measurement apparatus 2-2 calculates, as the second location data, the location data L₂ that indicates the cable center position CC of the cable 9 by using the distance data D₂(1), the distance data D₂(2), the magnetic field sensor location MS-1, and the magnetic field sensor location MS-2.

### 3-6. Second location data storage process

Sixthly, the current measurement system 100-2 performs a second location data storage process (Step S206). For example, the current measurement apparatus 2-2 stores, as the second location data, three coordinates of the calculated cable center position CC or the location data L₂ including the distance r from the magnetic field sensor location MS in the second location data storage unit 24b-2.

### 3-7. Second location data reference process

Seventhly, the current measurement system 100-2 performs a second location data reference process (Step S207). For example, the current measurement apparatus 2-2 refers to, as the second location data, the location data L₂ that is stored in the second location data storage unit 24b-2.

### 3-8. Magnetic field data reference process

Eighthly, the current measurement system 100-2 performs a magnetic field data reference process (Step S208). For example, the current measurement apparatus 2-2 refers to the magnetic field data M that corresponds to the detection result of the magnetic field sensor 41 closest to the cable 9 from among the pieces of magnetic field data M that are magnetic field intensities (A/m) corresponding to the detection results of the plurality of magnetic field sensors 4 (41, 42, ...) and that are stored in the current data storage unit 24c.

### 3-9. Current data calculation process

Ninthly, the current measurement system 100-2 performs a current data calculation process (Step S209). For example, the current measurement apparatus 2-2 the current data A that indicates the current value (A) of the current I that flows through the cable 9 by using the location data L₂ and the magnetic field data M at regular time intervals.

### 3-10. Current data storage process

Tenthly, the current measurement system 100-2 performs a current data storage process (Step S210), and terminates the process. For example, the current measurement apparatus 2-2 stores the calculated current data A in the current data storage unit 24c. In this case, the current measurement apparatus 2-2 may display the calculated current data A as a waveform of the current I on the output unit 22 that is a display.

### 4. Effects of second embodiment

Effects of the second embodiment will be described. In the following, a first effect and a second effect corresponding to the processes according to the second embodiment will be described.

### 4-1. First effect

Firstly, in the process according to the second embodiment as described above, the current measurement system 100-2 includes the magnetic field shield 3 that is configured to capture, to the inside thereof, the magnetic field H that is generated by the current I that flows through the cable 9, the magnetic field sensors 4 that are installed inside the magnetic field shield 3, and the current measurement apparatus 2-2. The current measurement apparatus 2-2 acquires detection results of the plurality of magnetic field sensors 4 (41, 42, ...) that are arranged at different locations, identifies the cable center position CC of the cable 9 based on the acquired detection results of the plurality of magnetic field sensors 4 (41, 42, ...), and calculates the current value (A) of the current I that flows through the cable 9 based on the identified cable center position CC and the acquired detection results of the magnetic field sensors 4. Therefore, in this process, by using the plurality of magnetic field sensors 4 (41, 42, ...) as the predetermined sensors for detecting the cable 9, it is possible to improve measurement accuracy of the current I that flows through the cable 9.

### 4-2. Second effect

Secondly, in the process according to the second embodiment as described above, the current measurement apparatus 2-2, calculates the current value (A) of the current I that flows through the cable 9 based on at least the detection result of the single magnetic field sensor 4 among the plurality of magnetic field sensors 4 (41, 42, ...) and the identified cable center position CC. Therefore, in this process, by using an arbitrary detection result from among the detection results of the plurality of magnetic field sensors 4 (41, 42, ...), it is possible to improve measurement accuracy of the current I that flows through the cable 9.

### Third embodiment

A configuration and a process of a current measurement system 100-3 according to a third embodiment, a configuration and a process of each of apparatuses of the current measurement system 100-3, the flow of each of processes of the current measurement system 100-3, and effects of the third embodiment will be described below. Meanwhile, explanation of the same configurations and the same processes as those of the first embodiment or the second embodiment will be omitted.

### 1. Configuration and process of current measurement system 100-3

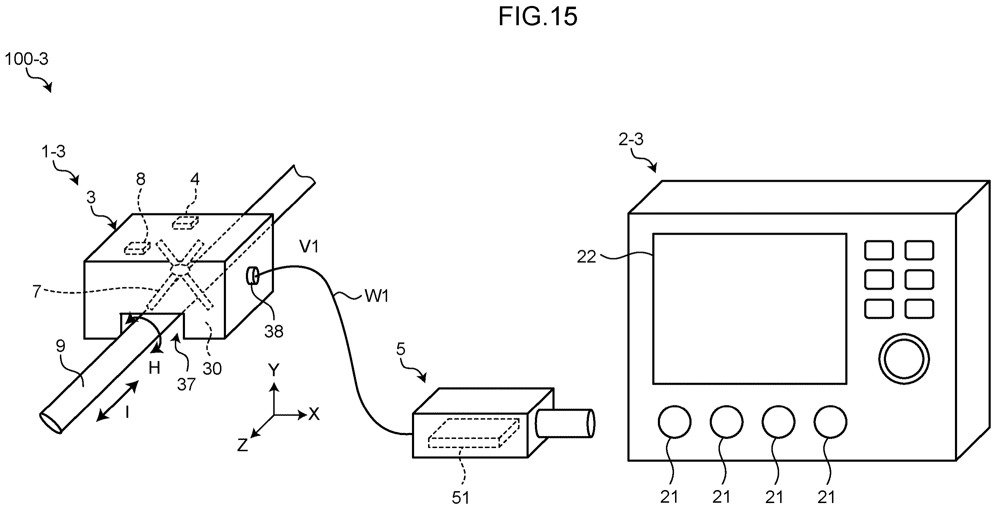

A configuration and a process of the current measurement system 100-3 according to the third embodiment will be described with reference to FIG. 15. In the following, a configuration example of the entire the current measurement system 100-3, a configuration example of a sensor head 1-3, a process example of the current measurement system 100-3, and effects of the current measurement system 100-3 will be described. Meanwhile, a configuration example of the magnetic field shield 3 and a configuration example of the cable 9 are the same as those of the first embodiment, and therefore, explanation thereof will be omitted.

### 1-1. Configuration example of entire current measurement system 100-3

A configuration example of the entire current measurement system 100-3 will be described with reference to FIG. 15. The current measurement system 100-3 includes the sensor head 1-3, a current measurement apparatus 2-3, the probe 5, and a cable fixture 7. FIG. 15 is a diagram illustrating a configuration example and a process example of the current measurement system 100-3 according to the third embodiment. Here, the sensor head 1-3, the current measurement apparatus 2-3, and the probe 5 are communicably connected to one another in a wired or wireless manner via a predetermined communication network. Meanwhile, as the predetermined communication network, it is possible to adopt various kinds of communication networks, such as the Internet or a dedicated line.

### 1-1-1. Sensor head 1-3

The sensor head 1-3 is a sensor device that is installed in the cable 9 that is a conductor as a measurement target by the cable fixture 7, and measures the magnetic field H that is generated by the current I that flows through the cable 9. The sensor head 1-3 is covered by the magnetic field shield 3 that has a partly-opened bottom surface, and the magnetic field sensor 4 and a state sensor 8 are installed inside the sensor head 1-3. Meanwhile, the current measurement system 100-3 illustrated in FIG. 15 may include the plurality of sensor heads 1-3. Meanwhile, the direction of the current I, the direction of the magnetic field, and the XYZ coordinate system are the same as those of the first embodiment, and therefore, explanation thereof will be omitted.

The magnetic field shield 3 captures (a part of) the magnetic field H that is generated by the current I that flows through the cable 9 into the internal space 30 via the opening portion 37. Further, the magnetic field sensor 4 detects the magnetic field H that is captured into the internal space 30 of the magnetic field shield 3 and outputs the sensor voltage value V1. In this case, the magnetic field sensor 4 outputs the sensor voltage value V1 to the detection circuit 51 that is incorporated in the probe 5, via the terminal 38 of the magnetic field shield 3 and the wiring W1. Furthermore, the state sensor 8 outputs a sensor value that is a detection result to the current measurement apparatus 2-3 via a predetermined communication network (not illustrated).

### 1-1-2. Current measurement apparatus 2-3

The current measurement apparatus 2-3 is an apparatus that identifies the cable center position CC of the cable 9 that is a conductor as a measurement target, and measures the current I that flows through the cable 9. Meanwhile, the current measurement system 100-3 illustrated in FIG. 15 may include the plurality of current measurement apparatuses 2-3. Further, in the example illustrated in FIG. 15, a case is illustrated in which the current measurement apparatus 2-3 is implemented by an oscilloscope, but the current measurement apparatus 2-3 may be implemented by a desktop PC, a notebook PC, a smartphone, a server apparatus, a cloud system, or the like.

The current measurement apparatus 2-3 includes the input unit 21 and the output unit 22. In the example illustrated in FIG. 15, the input unit 21 is an input terminal and connected to the probe 5. Further, the output unit 22 is a display and displays a waveform of the measured current I.

### 1-1-3. Probe 5

The probe 5 is a device that is communicably connected between the current measurement apparatus 2-3 and the sensor head 1-3 by the wiring W1 and incorporates therein the detection circuit 51 that converts the sensor voltage value V1 that is detected by the sensor head 1-3. Meanwhile, the current measurement system 100-3 illustrated in FIG. 15 may include the plurality of probes 5. Further, the probe 5 may be integrated with the current measurement apparatus 2-3 or the sensor head 1-3.

### 1-1-4. Cable fixture 7

The cable fixture 7 is an instrument for fixing the cable 9 to the sensor head 1-3. Meanwhile, the current measurement system 100-3 illustrated in FIG. 15 may include the plurality of cable fixtures 7.

### 1-2. Configuration example of sensor head 1-3

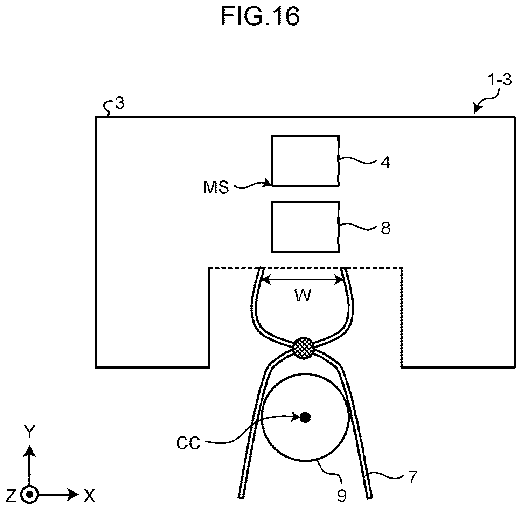

A configuration example of the sensor head 1-3 will be described with reference to FIG. 16. FIG. 16 is a diagram illustrating a configuration example of the sensor head 1-3 according to the third embodiment. The sensor head 1-3 includes the magnetic field shield 3, the magnetic field sensor 4, and the state sensor 8. In the example illustrated in FIG. 16, the sensor head 1-3 is mounted on the cable 9 via the cable fixture 7 so as to pass through the opening portion 37 below the magnetic field sensor 4. In this case, the sensor head 1-3 may use, for example, a hook-shaped member, a ring-shaped member or the like for mounting the magnetic field shield 3 on the cable fixture 7, or a spring member for fixing the mounted state. Further, the sensor head 1-3 may include the magnetic field sensor 4 inside the magnetic field shield 3 such that the magnetic field sensor 4 is located in the vertical direction of the cable 9, or may include the magnetic field sensor 4 inside the magnetic field shield 3 such that the magnetic field sensor 4 is located so as to deviate from the vertical direction of the cable 9, but the installation location of the magnetic field sensor 4 is not specifically limited. Furthermore, an installation location of the state sensor 8 is not specifically limited as long as the sensor head 1-3 includes the state sensor 8 at a location at which a state, such as a deformation amount W, of the cable fixture 7 is detectable. In the following explanation, the installation location of the magnetic field sensor 4 in the XZ plane direction of the sensor head 1-3 is referred to as the magnetic field sensor location MS, and the center of the cable 9 in the XY plane direction located closest to the magnetic field sensor location MS is referred to as the cable center position CC.

### 1-3. Configuration example of cable fixture 7

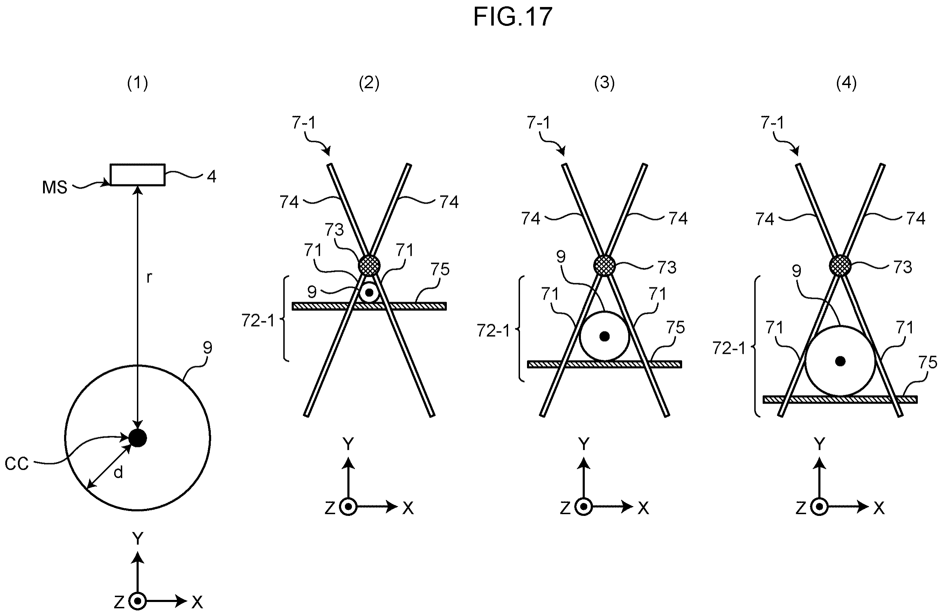

A configuration example of the cable fixture 7 will be described with reference to FIG. 17 to FIG. 20. In the following, a cable fixture 7-1 will be described as a configuration example 1 of the cable fixture 7, and a cable fixture 7-2 will be described as a configuration example 2 of the cable fixture 7.

### 1-3-1. Configuration example 1

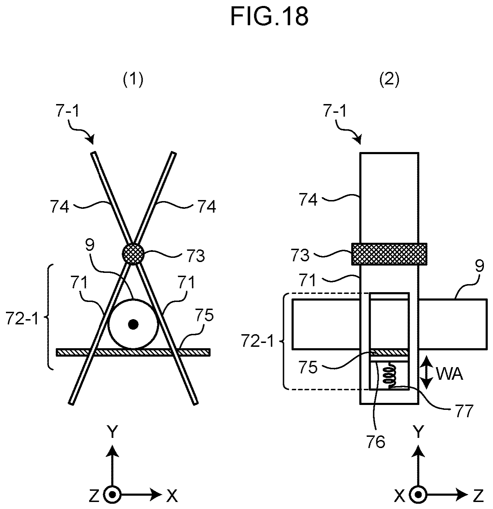

The cable fixture 7-1 will be described as the configuration example 1 of the cable fixture 7 with reference to FIG. 17 and FIG. 18. FIG. 17 is a diagram illustrating a configuration example 1-1 of the cable fixture 7 according to the third embodiment. FIG. 18 is a diagram illustrating a configuration example 1-2 of the cable fixture 7 according to the third embodiment. In the following, as the configuration example 1 of the cable fixture 7, the cable fixture 7-1 in which with a holder portion 71 for holding the cable 9 is non-deformable will be described.

FIG. 17(1) is a schematic diagram viewed in the XY plane direction of the cable 9. As illustrated in FIG. 17(1), the current measurement system 100-3 identifies the accurate cable center position CC of the cable 9 for accurately measuring the current I that flows through the cable 9, and accurately calculates the distance r (m) from the magnetic field sensor location MS of the magnetic field sensor 4 to the cable center position CC. In this case, the current measurement system 100-3 measures the deformation amount W of a deformation portion 72-1 of the cable fixture 7-1, calculates the cable radius d of the cable 9 in accordance with the measured deformation amount W, and identifies the cable center position CC by using the calculated cable radius d and a fixture location CF that indicates an installation location of the cable fixture 7 and that is a setting value.

FIG. 17(2) to FIG. 17(4) are schematic diagrams viewed in XY plane directions of the cable fixture 7-1 and the cable 9. As illustrated in FIG. 17(2) to FIG. 17(4), the cable fixture 7-1 includes the holder portion 71, the deformation portion 72-1, a base portion 73, extended portions 74, and a lower contact portion 75. In the cable fixture 7-1, the holder portion 71 and the extended portions 74 that form a scissors-like form with the base portion 73 as a hinge point are not deformed when the cable 9 is pushed into and fixed to the cable fixture 7-1. In contrast, in the cable fixture 7-1, the lower contact portion 75 allows the cable 9 to be pushed and come into contact with the holder portion 71 from a lower side and comes into contact with and locks the cable 9 from the lower side so as not to form a gap. In other words, in the cable fixture 7-1, the lower contact portion 75 corresponds to the deformation portion 72-1 that moves in the Y-axis direction in accordance with the cable radius d of the cable 9. In the example illustrated in FIG. 17(2) to FIG. 17(4), it is indicated that the lower contact portion 75 moves further in an upward direction with decrease in the cable radius d of the cable 9, and the lower contact portion 75 moves further in a downward direction with increase in the cable radius d of the cable 9.

FIG. 18(1) is a schematic diagram viewed in the XY plane directions of the cable fixture 7-1 and the cable 9. FIG. 18(2) corresponds to FIG. 18(1) and is a schematic diagram viewed in YZ plane directions of the cable fixture 7-1 and the cable 9. As illustrated in FIG. 18(1) and FIG. 18(2), the cable fixture 7-1 may further include, as the deformation portion 72-1, a plate 76 and a spring 77 in addition to the lower contact portion 75. In the example illustrated in FIG. 18(2), it is indicated that the spring 77 that is connected to the plate 76 is pushed into the lower contact portion 75 in accordance with the cable radius d of the cable 9, and the cable radius d increases with decrease in a width WA from the plate 76 to a bottom end of the spring 77. In other words, in the current measurement system 100-3, it is possible to calculate the cable radius d of the cable 9 by detecting the width WA of the cable fixture 7-1 by the state sensor 8, and then identify the cable center position CC.

### 1-3-2. Configuration example 2

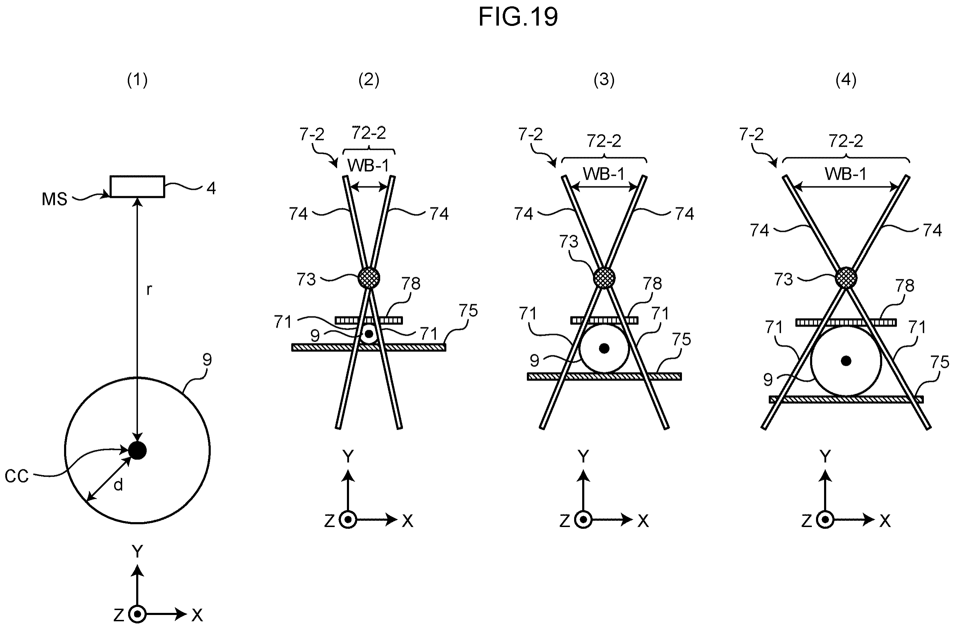

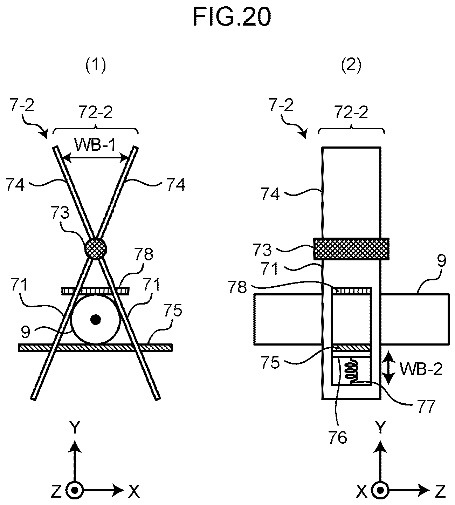

The cable fixture 7-2 will be described as the configuration example 2 of the cable fixture 7 with reference to FIG. 19 and FIG. 20. FIG. 19 is a diagram illustrating a configuration example 2-1 of the cable fixture 7 according to the third embodiment. FIG. 20 is a diagram illustrating a configuration example 2-2 of the cable fixture 7 according to the third embodiment. In the following, as the configuration example 2 of the cable fixture 7, the cable fixture 7-2 in which the holder portion 71 for holding the cable 9 is deformable.

FIG. 19(1) is a schematic diagram viewed in the XY plane direction of the cable 9. As illustrated in FIG. 19(1), the current measurement system 100-3 identifies the accurate cable center position CC of the cable 9 for accurately measuring the current I that flows through the cable 9, and accurately calculates the distance r (m) from the magnetic field sensor location MS of the magnetic field sensor 4 to the cable center position CC. In this case, the current measurement system 100-3 measures the deformation amount W of a deformation portion 72-2 of the cable fixture 7-2, calculates the cable radius d of the cable 9 in accordance with the measured deformation amount W, and identifies the cable center position CC by using the calculated cable radius d and the fixture location CF that is the installation location of the cable fixture 7 and that is a setting value.

FIG. 19(2) to FIG. 19(4) are schematic diagrams viewed in the XY plane directions of the cable fixture 7-2 and the cable 9. As illustrated in FIG. 19(2) to FIG. 19(4), the cable fixture 7-2 includes the holder portion 71, the deformation portion 72-2, the base portion 73, the extended portions 74, the lower contact portion 75, and an upper contact portion 78. In the cable fixture 7-2, the holder portion 71 and the extended portions 74 that form a scissors-like form with the base portion 73 as a hinge point are deformed when the cable 9 is pushed into and fixed to the cable fixture 7-2. In contrast, in the cable fixture 7-2, the lower contact portion 75 allows the cable 9 to be pushed and come into contact with the upper contact portion 78 fixed to the holder portion 71 from a lower side, and comes into contact with and locks the cable 9 from the lower side so as not to form a gap. In other words, in the cable fixture 7-2, the extended portions 74 correspond to the deformation portion 72-2 that moves such that paired components are opened in the X-axis direction in accordance with the cable radius d of the cable 9. In the examples illustrated in FIG. 19(2) to FIG. 19(4), it is indicated a deformation width WB-1 of opening between the extended portions 74 decreases with decrease in the cable radius d of the cable 9, and the deformation width WB-1 of the opening between the extended portions 74 increases with increase in the cable radius d of the cable 9.

FIG. 20(1) is a schematic diagram viewed in the XY plane directions of the cable fixture 7-2 and the cable 9. FIG. 20(2) corresponds to FIG. 20(1) and is a schematic diagram viewed in YZ plane directions of the cable fixture 7-2 and the cable 9. As illustrated in FIG. 20(1) and FIG. 20(2), the cable fixture 7-2 may further include, as the deformation portion 72-2, the plate 76 and the spring 77 in addition to the lower contact portion 75 and the upper contact portion 78. In the example illustrated in FIG. 20(2), it is indicated that the spring 77 that is connected to the plate 76 is pushed into the lower contact portion 75 in accordance with the cable radius d of the cable 9, and the cable radius d increases with decrease in a deformation width WB-2 from an upper part of the plate 76 to a bottom end of the spring 77. In other words, in the current measurement system 100-3, it is possible to calculate the cable radius d of the cable 9 by detecting the deformation width WB-1 or the deformation width WB-2 of the cable fixture 7-1 by the state sensor 8, and then identify the cable center position CC.

### 1-3. Process example of current measurement system 100

A process example of the current measurement system 100-3 will be described. In the following, a width data measurement process, a width data acquisition process, a cable center position identification process, and a current data calculation process will be described. Meanwhile, the processes as described above may be performed in a different order. Further, any of the processes as described above may be omitted.

### 1-3-1. Width data measurement process

Firstly, the sensor head 1-3 measures width data D₃ that indicates the state of the cable fixture 7. In this case, the sensor head 1-3 measures the width data D₃ that indicates the deformation amount W of a deformation portion 72 of the cable fixture 7 and that is detected by the state sensor 8.

### 1-3-2. Width data acquisition process

Secondly, the current measurement apparatus 2-3 acquires the width data D₃ from the sensor head 1-3. For example, the current measurement apparatus 2-3 acquires the width data D₃ corresponding to the detection result of the state sensor 8 from the sensor head 1-3.

### 1-3-3. Cable center position identification process

Thirdly, the current measurement apparatus 2-3 identifies the cable center position CC of the cable 9. For example, the current measurement apparatus 2-3 identifies the cable center position CC of the cable 9 by using the width data D₃ that corresponds to the detection result of the state sensor 8. In this case, the current measurement apparatus 2-3 identifies the cable center position CC by further using the fixture location CF of the cable fixture 7 that is a setting value and the magnetic field sensor location MS of the magnetic field sensor 4.

### 1-3-4. Current data calculation process

Fourthly, the current measurement apparatus 2-3 calculates the current data A of the current I that flows through the cable 9. For example, the current measurement apparatus 2-3 calculates the current data A that indicates the current value (A) of the current I that flows through the cable 9 at regular time intervals by using the identified cable center position CC of the cable 9 and the magnetic field data M that is acquired from the magnetic field sensor 4.

### 1-4. Effect of current measurement system 100-3

An overview of the current measurement system 100-3 according to the third embodiment will be first described, and thereafter, an effect of the current measurement system 100-3 will be described.

### 1-4-1. Overview of current measurement system 100-3

An overview of the current measurement system 100-3 according to the third embodiment will be described. The current measurement system 100-3 performs processes as described below. Firstly, the sensor head 1-3 measures the width data D₃ that indicates the state of the cable fixture 7 via the state sensor 8. Secondly, the current measurement apparatus 2-3 acquires the width data D₃ from the sensor head 1-3. Thirdly, the current measurement apparatus 2-3 identifies the cable center position CC of the cable 9 by using the width data D₃. Fourthly, the current measurement apparatus 2-3 calculates the current data A that indicates the current value (A) of the current I that flows through the cable 9 by using the cable center position CC and the magnetic field data M.

### 1-4-2. Effect of current measurement system 100-3

An effect of the current measurement system 100-3 according to the third embodiment will be described. The current measurement system 100-3 includes the sensor head 1-3 that is installed in the cable 9 by the cable fixture 7, collects the width data D₃ corresponding to the deformation amount W of the cable fixture 7 by the state sensor 8 that detects the state of the cable fixture 7, and accurately identifies the cable center position CC for calculating the current value (A) of the current I that flows through the cable 9. Therefore, the current measurement system 100-3 is able to improve measurement accuracy of the current I that flows through the cable 9.

### 2. Configuration and process of each of apparatuses of current measurement system 100-3

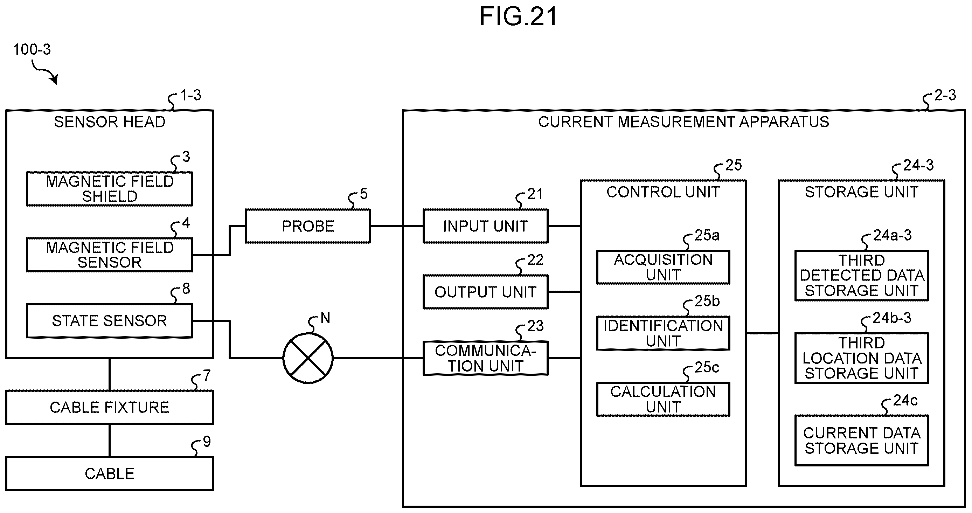

A configuration and a process of each of apparatuses included in the current measurement system 100-3 illustrated in FIG. 15 will be described with reference to FIG. 21 to FIG. 23. In the following, a configuration example of the entire current measurement system 100-3 according to the third embodiment, a configuration example and a process example of the sensor head 1-3, a configuration example and a process example of the current measurement apparatus 2-3, a configuration example and a process example of the probe 5, and a configuration example and a process example of the cable fixture 7 will be described.

### 2-1. Configuration example of entire current measurement system 100-3

A configuration example of the entire current measurement system 100-3 illustrated in FIG. 15 will be described with reference to FIG. 21. FIG. 21 is a block diagram illustrating a configuration example of each of apparatuses of the current measurement system 100-3 according to the third embodiment. As illustrated in FIG. 21, the current measurement system 100-3 includes the sensor head 1-3, the current measurement apparatus 2-3, the probe 5, and the cable fixture 7. Further, the sensor head 1-3 and the current measurement apparatus 2-3 are communicably connected to each other by a dedicated line or the like via the probe 5. Furthermore, the current measurement apparatus 2-3 and the state sensor 8 is communicably connected by the communication network N that is implemented by the Internet, a dedicated line, or the like.

### 2-2. Configuration example and process example of sensor head 1-3

A configuration example and a process example of the sensor head 1-3 will be described with reference to FIG. 21. As illustrated in FIG. 21, the sensor head 1-3 includes the magnetic field shield 3, the magnetic field sensor 4, and the state sensor 8.

### 2-2-1. Magnetic field shield 3

The magnetic field shield 3 is configured to capture, to the inside thereof, the magnetic field H that is generated by the current I that flows through the cable 9 as the conductor. Further, the magnetic field shield 3 is configured to shield the magnetic field H. The magnetic field shield 3 may be made by using various kinds of well-known materials, such as a metal material.

### 2-2-2. Magnetic field sensor 4

The magnetic field sensor 4 is installed in the magnetic field shield 3. Further, the magnetic field sensor 4 detects the magnetic field H at the magnetic field sensor location MS that is the installation location. For example, the magnetic field sensor 4 is an IC sensor that includes a Hall element, and may be referred to as an analog Hall IC or the like. Furthermore, the magnetic field sensor 4 may be a coil sensor that includes a coil. In this case, it may be possible to use a Rogowski coil as the magnetic field sensor 4, which enables downsizing and makes it possible to easily arrange the magnetic field sensor 4 in the magnetic field shield 3.

### 2-2-3. State sensor 8

The state sensor 8 is an example of the predetermined sensor that detects the cable 9. The state sensor 8 detects the state of the cable fixture 7. For example, the state sensor 8 detects the state of the cable fixture 7 based on an output value of stress, a piezoelectric element, a strain gauge, or the like of the spring 77. Further, the state sensor 8 detects the deformation amount W of the deformation portion 72 of the cable fixture 7. In this case, the state sensor 8 detects the width WA that indicates a displacement amount of the spring 77 included in the deformation portion 72-1. Further, the state sensor 8 detects the width WB that indicates a distance between a pair of the extended portions 74 included in the deformation portion 72-2. Meanwhile, in the example illustrated in FIG. 21, the state sensor 8 is installed inside the sensor head 1-3, but the state sensor 8 may be installed outside the sensor head 1-3 or it may be possible to install the plurality of state sensors 8.

### 2-3. Configuration example and process example of current measurement apparatus 2-3

A configuration example and a process example of the current measurement apparatus 2-3 will be described with reference to FIG. 21. As illustrated in FIG. 21, the current measurement apparatus 2-3 includes the input unit 21, the output unit 22, the communication unit 23, a storage unit 24-3, and the control unit 25. Meanwhile, the input unit 21, the output unit 22, and the communication unit 23 are the same as those of the first embodiment, and therefore, explanation thereof will be omitted.

### 2-3-1. Storage unit 24-3

The storage unit 24-3 stores therein various kinds of information that are referred to when the control unit 25 operates and various kinds of information that are acquired when the control unit 25 operates. The storage unit 24-3 includes a third detected data storage unit 24a-3, a third location data storage unit 24b-3, and the current data storage unit 24c. Here, the storage unit 24-3 may be implemented by, for example, a semiconductor memory device, such as a RAM or a flash memory, a storage device, such as a hard disk or an optical disk, or the like. Meanwhile, in the example illustrated in FIG. 21, the storage unit 24-3 is installed inside the current measurement apparatus 2-3, but the storage unit 24-3 may be installed outside the current measurement apparatus 2-3 or it may be possible to install a plurality of storage units. Further, the current data storage unit 24c is the same as the first embodiment, and therefore, explanation thereof will be omitted.

### 2-3-1-1. Third detected data storage unit 24a-3

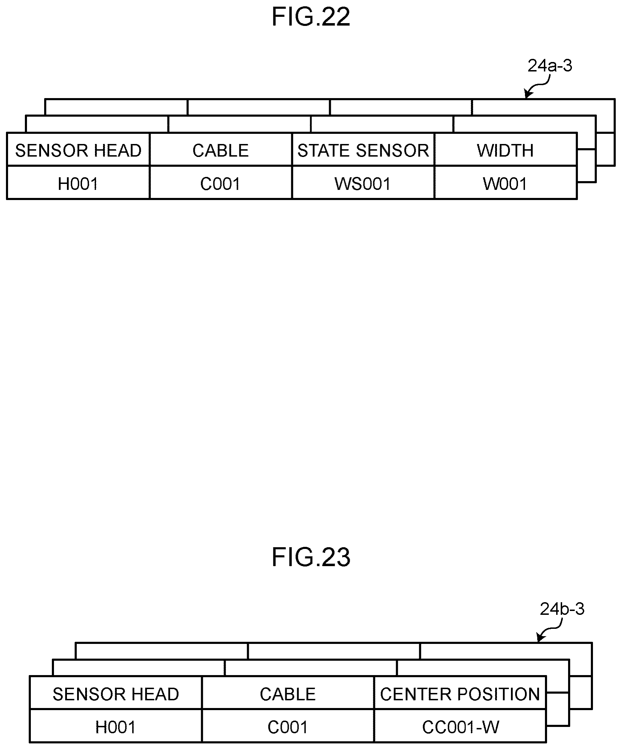

The third detected data storage unit 24a-3 stores therein third detected data. For example, the third detected data storage unit 24a-3 stores therein, as the third detected data, the width data D₃ that corresponds to the sensor value detected by the state sensor 8 and that is acquired by the acquisition unit 25a of the control unit 25 (to be described later). An example of data that is stored in the third detected data storage unit 24a-3 will be described below with reference to FIG. 22. FIG. 22 is a diagram illustrating an example of the third detected data storage unit 24a-3 of the current measurement apparatus 2-3 according to the third embodiment. In the example illustrated in FIG. 22, the third detected data storage unit 24a-3 includes items such as a "sensor head", a "cable", a "state sensor", and a "width".

The "sensor head" indicates identification information for identifying the sensor head 1-3, and is, for example, an identification number or an identification symbol of the sensor head 1-3. The "cable" indicates identification information for identifying the cable 9 that is a conductor wire as a measurement target, and is, for example, an identification number or an identification symbol of the cable 9 on which the sensor head 1-3 is mounted. The "state sensor" indicates identification information for identifying the state sensor 8, and is, for example, an identification number or an identification symbol of the state sensor 8. The "width" is the width data D₃ that is one of the deformation amounts W of the state of the cable fixture 7 detected by the state sensor 8, and is represented by, for example, millimeters (mm), centimeters (cm), meters (m), or the like.

Specifically, FIG. 22 illustrates an example in which the third detected data storage unit 24a-3 stores therein data or the like including the width data D₃ of {state sensor: "WS001", width: "WO01"}, with respect to the sensor head 1-3 that is identified by "H001" and the cable 9 that is identified by "C001".

### 2-3-1-2. Third location data storage unit 24b-3

The third location data storage unit 24b-3 stores therein the third location data. For example, the third location data storage unit 24b-3 stores therein location data L₃ that indicates the cable center position CC of the cable 9 and that is identified from the width data D₃ by the identification unit 25b of the control unit 25 (to be described later). An example of data that is stored in the third location data storage unit 24b-3 will be described below with reference to FIG. 23. FIG. 23 is a diagram illustrating an example of the third location data storage unit 24b-3 of the current measurement apparatus 2-3 according to the third embodiment. In the example illustrated in FIG. 23, the third location data storage unit 24b-3 includes items such as a "sensor head", a "cable", and a "center position".

The "sensor head" indicates the identification information for identifying the sensor head 1-3, and is, for example, the identification number or the identification symbol of the sensor head 1-3. The "cable" indicates the identification information for identifying the cable 9 that is a conductor wire as a measurement target, and is, for example, the identification number or the identification symbol of the cable 9 on which the sensor head 1-3 is mounted. The "center position" is the location data L₃ that represents the cable center position CC of the cable 9, and is represented by, for example, three-dimensional coordinates of a point that passes through a center of a circle of the cable 9 in a cylindrical shape and that is the closest to the magnetic field sensor location MS of the magnetic field sensor 4, the distance r from the magnetic field sensor location MS, or the like.

Specifically, FIG. 23 illustrates an example in which the third location data storage unit 24b-3 stores therein data or the like including the location data L₃ of {center position: "CC001-W"}, with respect to the sensor head 1-3 that is identified by "H001" and the cable 9 that is identified by "C001".

### 2-3-2. Control unit 25

The control unit 25 controls the entire current measurement apparatus 2-3. The control unit 25 includes the acquisition unit 25a, the identification unit 25b, and the calculation unit 25c. Here, the control unit 25 may be implemented by, for example, an electronic circuit, such as a CPU or an MPU, or an integrated circuit, such as an ASIC or an FPGA.

### 2-3-2-1. Acquisition unit 25a

The acquisition unit 25a acquires various kinds of information. Meanwhile, the acquisition unit 25a may store various kinds of acquired information in the storage unit 24-3. In the following, a magnetic field data acquisition process and a third detected data acquisition process will be described.

### Magnetic field data acquisition process

The acquisition unit 25a performs the magnetic field data acquisition process. For example, the acquisition unit 25a acquires a detection result of the magnetic field sensor 4. In this case, the acquisition unit 25a acquires, as the magnetic field data M that is the detection result, magnetic field intensity (A/m) or the like that is converted by the probe 5 in accordance with the sensor voltage value V1 that is detected by the magnetic field sensor 4 at the magnetic field sensor location MS.

A specific example of the magnetic field data acquisition process will be described. Firstly, the acquisition unit 25a acquires {time: "T001", magnetic field: "M001"}, {time: "T002", magnetic field: "M002"}, {time: "T003", magnetic field: "M003"}, ... as the magnetic field data M that is detected by the magnetic field sensor 4 identified by "MS001" and that is converted by the probe 5, with respect to the sensor head 1-3 that is identified by "H001" and the cable 9 that is identified by "C001". Secondly, the acquisition unit 25a stores the acquired magnetic field data M in the current data storage unit 24c.

Meanwhile, the acquisition unit 25a may acquire, as the magnetic field data M, the sensor voltage value V1 that is detected by the magnetic field sensor 4, and store the sensor voltage value V1 in the current data storage unit 24c. Further, the acquisition unit 25a may acquire, as the magnetic field data M, the sensor voltage value V1 that is detected by the magnetic field sensor 4, convert the acquired sensor voltage value V1 to the magnetic field intensity (A/m), and store the converted magnetic field intensity (A/m) in the current data storage unit 24c.

### Third detected data acquisition process

The acquisition unit 25a performs the third detected data acquisition process. For example, the acquisition unit 25a acquires, as the third detected data, a detection result of a predetermined sensor. In this case, the predetermined sensor includes the state sensor 8, and the acquisition unit 25a acquires a detection result of the state sensor 8 as the detection result of the predetermined sensor. Furthermore, the acquisition unit 25a acquires the width data D₃ that is one of the deformation amounts W of the state of the cable fixture 7 and that corresponds to a sensor value of the state sensor 8.

A specific example of the third detected data acquisition process will be described. Firstly, with respect to the sensor head 1-3 that is identified by "H001" and the cable 9 that is identified by "C001", the acquisition unit 25a acquires "WO01" as the width data D₃ that is detected by the state sensor 8 that is identified by "CS001". Secondly, the acquisition unit 25a stores the acquired width data D₃ in the third detected data storage unit 24a-3.

Meanwhile, the acquisition unit 25a may acquire, as the width data D₃, a sensor voltage value V-W that is detected by the state sensor 8, and store the sensor voltage value V-W in the third detected data storage unit 24a-3. Furthermore, the acquisition unit 25a may acquire, as the width data D₃, the deformation amount W that is the distance (m) that is converted by the probe 5 in accordance with the sensor voltage value V-W that is detected by the state sensor 8, and store the deformation amount W in the third detected data storage unit 24a-3. Moreover, the acquisition unit 25a may acquire, as the width data D₃, the sensor voltage value V-W that is detected by the state sensor 8, convert the acquired sensor voltage value V-W to the deformation amount W that is a distance (m), and store the converted deformation amount W in the third detected data storage unit 24a-3.

### 2-3-2-2. Identification unit 25b

The identification unit 25b identifies various kinds of information. Meanwhile, the identification unit 25b may store various kinds of the identified information in the storage unit 24-2. A location data output process will be described below.

### Location data output process

The identification unit 25b performs the location data output process. For example, the identification unit 25b identifies the cable center position CC of the cable 9 as the conductor by using a detection result (third detected data) of the acquired state sensor 8. In this case, the identification unit 25b identifies the cable center position CC of the cable 9 by using the acquired width data D₃.

A specific example of the location data output process will be described below. Firstly, with respect to the sensor head 1-3 that is identified by "H001" and the cable 9 that is identified by "C001", the identification unit 25b refers to the width data D₃ of {state sensor: "CS001", width: "WO01"} as the third detected data that is stored in the third detected data storage unit 24a-3. Secondly, with respect to the sensor head 1-3 that is identified by "H001" and the cable 9 that is identified by "C001", the identification unit 25b refers to "L001-MS" that is the magnetic field sensor location MS of the magnetic field sensor 4 as a setting value that is stored in the storage unit 24-3. Thirdly, with respect to the sensor head 1-3 that is identified by "H001" and the cable 9 that is identified by "C001", the identification unit 25b refers to "L001-CF" that is the fixture location CF of the cable fixture 7, as a setting value that is stored in the storage unit 24-3. Fourthly, with respect to the sensor head 1-3 that is identified by "H001" and the cable 9 that is identified by "C001", the identification unit 25b outputs the location data L₃ of {center position: "CC001-W"} by using the width data D₃, the magnetic field sensor location MS of the magnetic field sensor 4, and the fixture location CF of the cable fixture 7. Fourthly, the identification unit 25b stores the output location data L₃ in the third location data storage unit 24b-3.

### 2-3-2-3. Calculation unit 25c

The calculation unit 25c acquires various kinds of information. Meanwhile, the calculation unit 25c may store various kinds of the calculated information in the storage unit 24-3. A current data calculation process will be described below.

### Current data calculation process

The calculation unit 25c performs the current data calculation process. For example, the calculation unit 25c calculates, as the current data A, the current value (A) of the current I that flows through the cable 9 based on the identified cable center position CC of the cable 9 as the conductor and acquired detection result of the magnetic field sensor 4.

A specific example of the current data calculation process will be described below. Firstly, with respect to the sensor head 1-3 that is identified by "H001" and the cable 9 that is identified by "C001", the calculation unit 25c refers to the location data L₃ of {center position: "CC001-W"} as the third location data that is stored in the third location data storage unit 24b-3, and identifies the distance r (m) from the magnetic field sensor location MS of the magnetic field sensor 4 to the cable center position CC. Secondly, with respect to the sensor head 1-3 that is identified by "H001" and the cable 9 that is identified by "C001", the calculation unit 25c acquires {time: "T001", magnetic field: "M001"}, {time: "T002", magnetic field: "M002"}, {time: "T003", magnetic field: "M003"}, ... that are the magnetic field data M that is stored in the current data storage unit 24c. Thirdly, the calculation unit 25c calculates the current data A of {time: "T001", current: "A001"}, {time: "T002", current: "A002"}, {time: "T003", current: "A003"}, ... by assigning the distance r (m) and the magnetic field intensity (A/m) indicated by the magnetic field data M to Expression of H=I/(2πr) that is derived by the Ampere's circuital law. Fourthly, the calculation unit 25c stores the calculated current data A in the current data storage unit 24c.

Meanwhile, the calculation unit 25c may further use the distance data D₁ that is output from the distance sensors 6 according to the first embodiment, the distance data D₂ that is output from the plurality of magnetic field sensors 4 (41, 42, ...) according to the second embodiment, or the like.

### 2-4. Configuration example and process example of probe 5

A configuration example and a process example of the probe 5 will be described with reference to FIG. 15. The probe 5 includes the detection circuit 51 and converts a detection result of the magnetic field sensor 4. For example, the probe 5 converts the sensor voltage value V1 that is detected by the magnetic field sensor 4 to the magnetic field intensity (A/m). Further, the probe 5 may convert a sensor voltage value V-W that is detected by the state sensor 8 to the width data D₃.

### 2-5. Configuration example and process example of cable fixture 7

A configuration example of the cable fixture 7 will be described with reference to FIG. 15. The cable fixture 7 supports and fixes the cable 9 as the conductor to the magnetic field shield 3 of the sensor head 1-3. For example, the cable fixture 7 includes the holder portion 71 that has a holder width that decreases with approach to the opening portion 37 of the magnetic field shield 3 and that holds the cable 9, and the deformation portion 72 that is deformed by a deformation amount W corresponding to a certain position when the cable 9 is pushed into and located at the certain position in the holder portion 71 from an opposite side of the opening portion 37.

The cable fixture 7 includes the lower contact portion 75 that comes into contact with the cable 9 so as to push the cable 9 into the holder portion 71 from an opposite side of the opening portion 37 of the magnetic field shield 3. In this case, the deformation portion 72-1 of the cable fixture 7 includes the spring 77 that biases the lower contact portion 75 toward the opening portion 37 of the magnetic field shield 3. Further, the cable fixture 7 includes the base portion 73 that is connected to the holder portion 71 and the deformation portion 72-2. In this case, the deformation portion 72-2 of the cable fixture 7 includes the pair of the extended portions 74 that extend from the base portion 73 toward the opening portion 37 of the magnetic field shield 3, and a distance between the pair of the extended portions 74 of the deformation portion 72-2 changes as the cable 9 is pushed further into the holder portion 71.

### 3. Flow of each of processes of the current measurement system 100-3

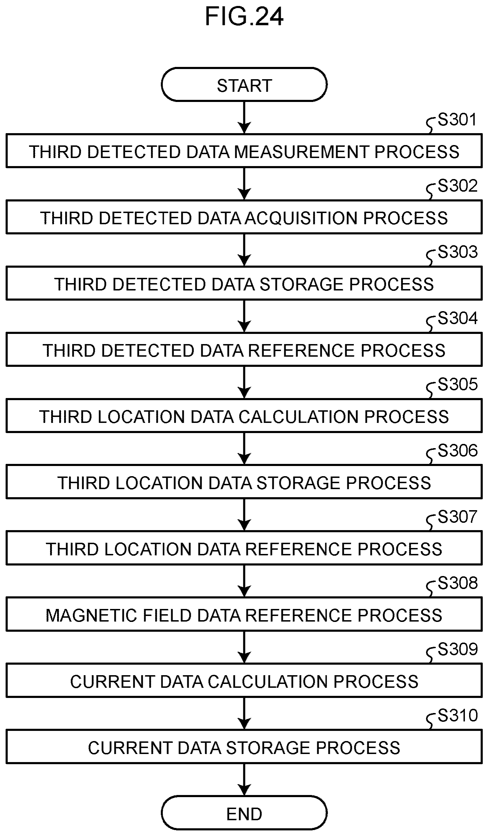

A flow of processes performed by the current measurement system 100-3 according to the third embodiment will be described with reference to FIG. 24. FIG. 24 is a flowchart illustrating an example of the flow of processes of the current measurement system 100-3 according to the third embodiment. Meanwhile, processes from Step S301 to Step S310 below may be performed in different order. Further, some of the processes from Step S301 to Step S310 below may be omitted.

### 3-1. Third detected data measurement process

Firstly, the current measurement system 100-3 performs a third detected data measurement process (Step S301). For example, the state sensor 8 outputs, as the third detected data, the width data D₃ that indicates a state of the cable fixture 7.

### 3-2. Third detected data acquisition process

Secondly, the current measurement system 100-3 performs the third detected data acquisition process (Step S302). For example, the current measurement apparatus 2-3 acquires, as the third detected data, the width data D₃ that indicates the state of the cable fixture 7 that is output by the state sensor 8.

### 3-3. Third detected data storage process

Thirdly, the current measurement system 100-3 performs a third detected data storage process (Step S303). For example, the current measurement apparatus 2-3 stores, as the third detected data, the width data D₃ that is acquired from the state sensor 8 in the third detected data storage unit 24a-3.

### 3-4. Third detected data reference process

Fourthly, the current measurement system 100-3 performs a third detected data reference process (Step S304). For example, the current measurement apparatus 2-3 refers to, as the third detected data, the width data D₃ that is stored in the third detected data storage unit 24a-3. Further, the current measurement apparatus 2-3 refers to the magnetic field sensor location MS of the magnetic field sensor 4 that is the setting value that is stored in the storage unit 24-3. Furthermore, the current measurement apparatus 2-3 refers to the fixture location CF of the cable fixture 7 that is the setting value that is stored in the storage unit 24-3.

### 3-5. Third location data calculation process

Fifthly, the current measurement system 100-3 performs a third location data calculation process (Step S305). For example, the current measurement apparatus 2-3 calculates, as the third location data, the cable radius d of the cable 9 and the location data L₃ that indicates the cable center position CC of the cable 9 by using the width data D₃, the magnetic field sensor location MS, and the fixture location CF of the cable fixture 7.

### 3-6. Third location data storage process

Sixthly, the current measurement system 100-3 performs a third location data storage process (Step S306). For example, the current measurement apparatus 2-3 stores, as the third location data, three coordinates of the calculated cable center position CC or the location data L₃ including the distance r from the magnetic field sensor location MS in the third location data storage unit 24b-3.

### 3-7. Third location data reference process

Seventhly, the current measurement system 100-3 performs a third location data reference process (Step S307). For example, the current measurement apparatus 2-3 refers to, as the third location data, the location data L₃ that is stored in the third location data storage unit 24b-3.

### 3-8. Magnetic field data reference process

Eighthly, the current measurement system 100-3 performs a magnetic field data reference process (Step S308). For example, the current measurement apparatus 2-3 refers to the magnetic field data M that is the magnetic field intensity (A/m) corresponding to the detection result of the magnetic field sensor 4 and that is stored in the current data storage unit 24c.

### 3-9. Current data calculation process

Ninthly, the current measurement system 100-3 performs the current data calculation process (Step S309). For example, the current measurement apparatus 2-3 calculates the current data A that indicates the current value (A) of the current I that flows through the cable 9 at regular time intervals by using the location data L₃ and the magnetic field data M.

### 3-10. Current data storage process

Tenthly, the current measurement system 100-3 performs current data storage process (Step S310), and terminates the process. For example, the current measurement apparatus 2-3 stores the calculated current data A in the current data storage unit 24c. In this case, the current measurement apparatus 2-3 may display the calculated current data A as a waveform of the current I on the output unit 22 that is a display.

### 4. Effects of third embodiment

Effects of the third embodiment will be described. In the following, a first effect to a fourth effect corresponding to the processes according to the third embodiment will be described.

### 4-1. First effect

Firstly, in the process according to the third embodiment as described above, the current measurement system 100-3 includes the magnetic field shield 3 that is configured to capture, to the inside thereof, the magnetic field H that is generated by the current I that flows through the cable 9, the magnetic field sensor 4 that is installed inside the magnetic field shield 3, the state sensor 8 that detects the state of the cable fixture 7, the current measurement apparatus 2-3, and the cable fixture 7 that supports and fixes the cable 9 to the magnetic field shield 3. The current measurement apparatus 2-3 acquires the detection result of the state sensor 8, identifies the cable center position CC of the cable 9 based on the acquired detection result of the state sensor 8, and calculates the current value (A) of the current I that flows through the cable 9 based on the identified cable center position CC and the acquired detection result of the magnetic field sensor 4. Therefore, in this process, by using the state sensor 8 that detects the state of the cable fixture 7 as the predetermined sensor for detecting the cable 9, it is possible to improve measurement accuracy of the current I that flows through the cable 9.

### 4-2. Second effect

Secondly, in the process according to the third embodiment as described above, the cable fixture 7 includes the holder portion 71 that has a holder width that decreases with approach to the opening portion 37 of the magnetic field shield 3 and that holds the cable 9, and the deformation portion 72 (72-1, 72-2) is are deformed by the deformation amount W corresponding to a certain position when the cable 9 is pushed into and located at the certain position in the holder portion 71 from an opposite side of the opening portion 37. The state sensor 8 detects the deformation amount W of the deformation portion 72 (72-1, 72-2). Therefore, in this process, by using, as the state of the cable fixture 7, the deformation amount W corresponding to the location of the cable 9, it is possible to improve measurement accuracy of the current I that flows through the cable 9.

### 4-3. Third effect

Thirdly, in the process according to the third embodiment as described above, the cable fixture 7 includes the lower contact portion 75 that comes into contact with the cable 9 so as to push the cable 9 into the holder portion 71 from the opposite side of the opening portion 37 of the magnetic field shield 3, and the deformation portion 72-1 includes the spring 77 that biases the lower contact portion 75 toward the opening portion 37. The state sensor 8 detects a displacement amount of the spring 77, and therefore, in this process, by using the displacement amount of the spring 77 corresponding to the location of the cable 9 as the state of the cable fixture 7, it is possible to improve measurement accuracy of the current I that flows through the cable 9.

### 4-4. Fourth effect

Fourthly, in the process according to the third embodiment as described above, the cable fixture 7 the base portion 73 that is connected to the holder portion 71 and the deformation portion 72-2, the deformation portion 72-2 includes the pair of extended portions 74 that extend from the base portion 73 toward the opening portion 37 of the magnetic field shield 3, and a distance between the pair of the extended portions 74 of the deformation portion 72-2 is changed as the cable 9 is pushed further to the inside of the holder portion 71. The state sensor 8 detects the distance between the pair of the extended portions 74 of the deformation portion 72-2. Therefore, in this process, by using the distance between the pair of the extended portions 74 corresponding to the location of the cable 9 as the state of the cable fixture 7, it is possible to improve measurement accuracy of the current I that flows through the cable 9.

### System

The processing procedures, control procedures, specific names, and information including various kinds of data and parameters illustrated in the above-described document and drawings may be arbitrarily changed unless otherwise specified.

Furthermore, the components of the apparatuses illustrated in the drawings are functionally conceptual and do not necessarily have to be physically configured in the manner illustrated in the drawings. In other words, specific forms of distribution and integration of the apparatuses are not limited to those illustrated in the drawings. That is, all or part of the apparatuses may be functionally or physically distributed or integrated in arbitrary units depending on various loads or use conditions.

Moreover, all or an arbitrary part of various kinds of processing functions that are implemented by the apparatuses may be realized by a CPU or a program that is analyzed and executed by the CPU, or may be realized by hardware using wired logic.

### Hardware

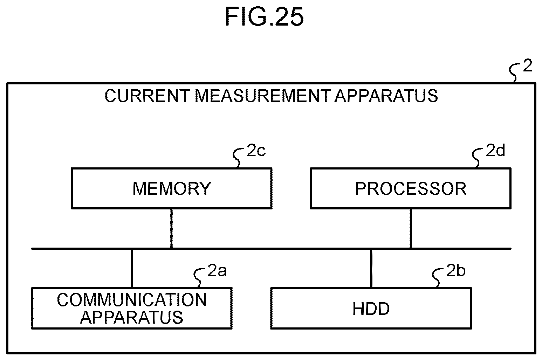

A hardware configuration example of a current measurement apparatus 2 (2-1, 2-2, 2-3) will be described. Meanwhile, the other apparatuses may have the same hardware configurations. FIG. 25 is a diagram illustrating a hardware configuration example according to the first embodiment to the third embodiment. As illustrated in FIG. 25, the current measurement apparatus 2 (2-1, 2-2, 2-3) includes a communication apparatus 2a, a Hard Disk Drive (HDD) 2b, a memory 2c, and a processor 2d. Further, all of units illustrated in FIG. 25 are connected to one another via a bus or the like.

The communication apparatus 2a is a network interface card or the like, and performs communication with a different server or the like. The HDD 2b stores therein a program or a database for implementing the functions as illustrated in FIG. 4, FIG. 11, and FIG. 21.

The processor 2d reads, from the HDD 2b or the like, a program that executes the same processes as those of each of the processing units illustrated in FIG. 4, FIG. 11, and FIG. 21, loads the program onto the memory 2c, and executes the processes that implement each of the functions illustrated in FIG. 4, FIG. 11, FIG. 21, or the like. For example, the processes implement the same functions as those of each of the processing units that are included in the current measurement apparatus 2 (2-1, 2-2, 2-3). Specifically, the processor 2d reads, from the HDD 2b or the like, a program that has the same functions as those of the acquisition unit 25a, the identification unit 25b, the calculation unit 25c, and the like. Further, the processor 2d executes a process for implementing the same processes as those of the acquisition unit 25a, the identification unit 25b, the calculation unit 25c, and the like.

In this manner, the current measurement apparatus 2 (2-1, 2-2, 2-3) operates as an apparatus that reads and executes the program to implement various kinds of processing methods. Further, the current measurement apparatus 2 (2-1, 2-2, 2-3) is able to implement the same functions as those of the first embodiments to the third embodiment by causing a medium reader to read the above-described program from a recording medium and execute the read program. Meanwhile, the program according to the first embodiment to the third embodiment need not always be executed by the current measurement apparatus 2 (2-1, 2-2, 2-3). For example, the present invention may be applied in the same manner even when a different computer or a different server the program executes the above-described program or the different computer and the different server execute the above-described program in a cooperative manner.

The program may be distributed via a network, such as the Internet. Further, the program may be recorded in a computer readable recording medium, such as a hard disk, a flexible disk (FD), a compact disc (CD)-ROM, a Magneto-Optical disk (MO), or a Digital Versatile Disk (DVD), and may be executed by being read from the recording medium by a computer.

According to one aspect of the present invention, it is possible to improve measurement accuracy of a current that flows through a conductor.

## Claims

1. A current measurement system (100) comprising:
a magnetic field shield (3) that is configured to capture, to an inside of the magnetic field shield (3), a magnetic field (H) that is generated by a current (I) that flows through a conductor;
a magnetic field sensor (4) that is installed inside the magnetic field shield (3);
a predetermined sensor; and
a current measurement apparatus (2), wherein
the predetermined sensor is a sensor for detecting the conductor,
the magnetic field sensor (4) detects a magnetic field (H) at an installation location, and
the current measurement apparatus (2) includes
an acquisition unit (25a) that acquires a detection result of the predetermined sensor and a detection result of the magnetic field sensor (4);
an identification unit (25b) that identifies a center position of the conductor based on the acquired detection result of the predetermined sensor; and
a calculation unit (25c) that calculates a current value of the current (I) that flows through the conductor based on the identified center position and the acquired detection result of the magnetic field sensor (4).

2. The current measurement system (100) according to claim 1, wherein the predetermined sensor includes a distance sensor (6) that measures a distance to the conductor.

3. The current measurement system (100) according to claim 2, wherein the distance sensor (6) includes a radar sensor.

4. The current measurement system (100) according to any one of claims 1 to 3, wherein the predetermined sensor includes an imaging sensor that captures an image of the conductor.

5. The current measurement system (100) according to any one of claims 1 to 4, wherein
the magnetic field sensor (4) includes a plurality of magnetic field sensors (4) that are installed at different locations,
the predetermined sensor includes the plurality of magnetic field sensors (4),
the acquisition unit (25a) acquires a detection result of each of the magnetic field sensors (4) as the detection result of the predetermined sensor, and
the identification unit (25b) identifies the center position of the conductor by using the acquired detection result of each of the magnetic field sensors (4).

6. The current measurement system (100) according to claim 5, wherein the calculation unit (25c) calculates the current value based on a detection result of at least one magnetic field sensor (4) among the plurality of magnetic field sensors (4) and the identified center position.

7. The current measurement system (100) according to any one of claims 1 to 6, wherein
the current measurement system (100) further includes a fixture (7) that supports and fixes the conductor to the magnetic field shield (3), and
the predetermined sensor detects a state of the fixture (7).

8. The current measurement system (100) according to claim 7, wherein
the fixture (7) includes
a holder portion that has a holder width that decreases with approach to an opening portion of the magnetic field shield (3) and that holds the conductor; and
a deformation portion that is deformed by a deformation amount corresponding to a certain position when the conductor is pushed into and located at the certain position in the holder portion from an opposite side of the opening portion, and
the predetermined sensor detects the deformation amount of the deformation portion.

9. The current measurement system (100) according to claim 8, wherein
the fixture (7) includes a contact portion that comes into contact with the conductor so as to push the conductor into the holder portion from an opposite side of the opening portion,
the deformation portion includes a spring that biases the contact portion toward the opening portion, and
the predetermined sensor detects a displacement amount of the spring.

10. The current measurement system (100) according to claim 8 or 9, wherein
the fixture (7) includes a base portion that is connected to the holder portion and the deformation portion,
the deformation portion includes a pair of extended portions that extend from the base portion toward the opening portion,
a distance between the pair of the extended portions of the deformation portion changes as the conductor is pushed further into the holder portion, and
the predetermined sensor detects the distance between the pair of the extended portions of the deformation portion.

11. A current measurement apparatus (2) comprising:
an acquisition unit (25a) that
acquires a detection result of a conductor that is detected by a predetermined sensor, and
acquires a detection result of a magnetic field (H) that is detected at an installation location by a magnetic field sensor (4) that is installed inside a magnetic field shield (3) that is configured to capture, to an inside of the magnetic field shield (3), a magnetic field (H) that is generated by a current (I) that flows through the conductor;
an identification unit (25b) that identifies a center position of the conductor based on the acquired detection result of the predetermined sensor; and
a calculation unit (25c) that calculates a current value of the current (I) that flows through the conductor based on the identified center position and the acquired detection result of the magnetic field sensor (4).

12. A current measurement method implemented by a computer (2), the current measurement method comprising:
acquiring a detection result of a conductor that is detected by a predetermined sensor;
acquiring a detection result of a magnetic field (H) that is detected at an installation location by a magnetic field sensor (4) that is installed inside a magnetic field shield (3) that is configured to capture, to an inside of the magnetic field shield (3), a magnetic field (H) that is generated by a current (I) that flows through the conductor;
identifying a center position of the conductor based on the acquired detection result of the predetermined sensor; and
calculating a current value of the current (I) that flows through the conductor based on the identified center position and the acquired detection result of the magnetic field sensor (4).

13. A current measurement program that causes a computer (2) to execute a process, the process comprising:
acquiring a detection result of a conductor that is detected by a predetermined sensor;
acquiring a detection result of a magnetic field (H) that is detected at an installation location by a magnetic field sensor (4) that is installed inside a magnetic field shield (3) that is configured to capture, to an inside of the magnetic field shield (3), a magnetic field (H) that is generated by a current (I) that flows through the conductor;
identifying a center position of the conductor based on the acquired detection result of the predetermined sensor; and
calculating a current value of the current (I) that flows through the conductor based on the identified center position and the acquired detection result of the magnetic field sensor (4).
